(19) Europäisches Patentamt
European Patent Office
Office européen des brevets

(11) **EP 1 515 251 B1**

(12) **EUROPEAN PATENT SPECIFICATION**

(45) Date of publication and mention
of the grant of the patent:
**03.03.2010 Bulletin 2010/09**

(51) Int Cl.:
***G06F 17/50*** *(2006.01)*

(21) Application number: **03020777.3**

(22) Date of filing: **12.09.2003**

(54) **Efficient approaches for bounded model checking**

Effiziente Ansätze für Bounded Model Checking

Approches efficaces pour la vérification de modèle limitée

(84) Designated Contracting States:
**BE DE FI IT NL**

(43) Date of publication of application:
**16.03.2005 Bulletin 2005/11**

(73) Proprietor: **NEC CORPORATION**
**Tokyo (JP)**

(72) Inventors:
• **Ganai, Malay**
**Princeton**
**New Jersey 08540 (US)**
• **Zhang, Lintao**
**Princeton**
**New Jersey 08540 (US)**
• **Gupta, Aarti**
**Princeton**
**New Jersey 08540 (US)**
• **Yang, Zijiang**
**Princeton**
**New Jersey 08540 (US)**
• **Ashar, Pranav**
**Princeton**
**New Jersey 08540 (US)**

(74) Representative: **Glawe, Delfs, Moll**
**Patent- und Rechtsanwälte**
**Postfach 26 01 62**
**80058 München (DE)**

(56) References cited:
**US-A1- 2002 178 424    US-B1- 6 324 496**

• EMERSON E A ET AL: "Modalities for model checking: branching time logic strikes back" SCIENCE OF COMPUTER PROGRAMMING, JUNE 1987, NETHERLANDS, vol. 8, no. 3, 1987, pages 275-306, XP002270170 ISSN: 0167-6423
• SHEERAN M ET AL: "Checking safety properties using induction and a SAT-solver" FORMAL METHODS IN COMPUTER-AIDED DESIGN. THIRD INTERNATIONAL CONFERENCE, FMCAD 2000. PROCEEDINGS (LECTURE NOTES IN COMPUTER SCIENCE VOL.1954), FORMAL METHODS IN COMPUTER-AIDED DESIGN. THIRD INTERNATIONAL CONFERENCE, FMCAD 2000. PROCEEDINGS, AUSTIN, T, 2000, pages 108-125, XP009025492 2000, Berlin, Germany, Springer-Verlag, Germany ISBN: 3-540-41219-0
• MOSKEWICZ M W ET AL: "Chaff: engineering an efficient SAT solver" PROCEEDINGS OF THE 38TH. ANNUAL DESIGN AUTOMATION CONFERENCE. (DAC). LAS VEGAS, NV, JUNE 18 - 22, 2001, PROCEEDINGS OF THE DESIGN AUTOMATION CONFERENCE, NEW YORK, NY: ACM, US, vol. CONF. 38, 18 June 2001 (2001-06-18), pages 530-535, XP010552444 ISBN: 1-58113-297-2
• BIERE A ET AL: "Symbolic model checking without BDDs" TOOLS AND ALGORITHMS FOR THE CONSTRUCTION AND ANALYSIS OF SYSTEMS. 5TH INTERNATIONAL CONFERENCE, TACAS'99. HELD AS PART OF THE JOINT EUROPEAN CONFERENCES ON THEORY AND PRACTICE OF SOFTWARE, ETAPS'99. PROCEEDINGS, PROCEEDINGS OF FIFTH INTERNATIONAL CO, pages 193-207, XP009025352 1999, Berlin, Germany, Springer-Verlag, Germany ISBN: 3-540-65703-7

**(Cont. next page)**

• BIERE A, CIMATTI A, CLARKE E M, STRICHMAN O, ZHU Y: "Bounded Model Checking (Preprint)" ADVANCES IN COMPUTERS (PREPRINT OF THE BMC ARTICLE), [Online] vol. 58, September 2003 (2003-09), XP002270195 Retrieved from the Internet: <URL:http://www.inf.ethz.ch/personal/biere /papers/BiereCimattiClarkeStrichmanZhu-Adv ances-58-2003-preprint.pdf> [retrieved on 2004-02-13]
• SHEERAN M ET AL: "A tutorial on Stalmarck's proof procedure for propositional logic" FORMAL METHODS IN COMPUTER-AIDED DESIGN. SECOND INTERNATIONAL CONFERENCE, FMCAD '98. PROCEEDINGS, FORMAL METHODS IN COMPUTER-AIDED DESIGN. SECOND INTERNATIONAL CONFERENCE, FMCAD '98, PALO ALTO, CA, USA, 4-6 NOV. 1998, [Online] pages 82-99, XP002270196 1998, Berlin, Germany, Springer-Verlag, Germany ISBN: 3-540-65191-8 Retrieved from the Internet: <URL:http:// citeseer.nj.nec.com/rd/8095738 3%2C49386%2C1%2C0.25%2CDownload/http: //cit eseer.nj.nec.com/cache/papers/cs/ 2574/http : zSzzSzwww.cs.chalmers.sezSz%7EmszSzFMC ADI atest.pdf/sheeran98tutorial.pdf> [retrieved on 2004-02-13]
• HAVERKORT B R ET AL: "On the use of model checking techniques for dependability evaluation" RELIABLE DISTRIBUTED SYSTEMS, 2000. SRDS-2000. PROCEEDINGS THE 19TH IEEE SYMPOSIUM ON NURNBERG, GERMANY 16-18 OCT. 2000, LOS ALAMITOS, CA, USA,IEEE COMPUT. SOC, US, 16 October 2000 (2000-10-16), pages 228-237, XP010523963 ISBN: 0-7695-0543-0
• ABRAHAM J A ET AL: "Verifying properties using sequential ATPG" PROCEEDINGS INTERNATIONAL TEST CONFERENCE 2002. ITC 2002. BALTIMORE, MD, OCT. 7-10, 2002, INTERNATIONAL TEST CONFERENCE, NEW YORK, NY: IEEE, US, 7 October 2002 (2002-10-07), pages 194-202, XP010609742 ISBN: 0-7803-7542-4
• CHEN H.; OHBO N.; OHNO T.: 'Processing queries with expensive predicates by filtering' COMPUTER SOFTWARE AND APPLICATIONS CONFERENCE, 1999. COMPSAC '99. 27 October 1999, LOS ALAMITOS, CA, USA, pages 350 - 356, XP010365484
• ROSS K.A.; ZAMAN K.A.: 'Optimizing selections over datacubes' SCIENTIFIC AND STATISTICAL DATABASE MANAGEMENT, 2000. 12TH INTERNATIONAL CONFERENCE 26 July 2000, BERLIN, GERMANY, pages 139 - 152, XP010542373

**Description**

# I. DESCRIPTION

## I.A. Field

This disclosure teaches techniques related to formal verification of digital circuits. Specifically, software, systems and methods for bounded model checking of temporal properties for digital circuits using novel partitioning, incremental learning and inductive proofs based on Boolean Satisfiability and Binary Decision Diagrams are proposed.

## I.B. Background

### 1. References

The following papers provide useful background information, for which they are incorporated herein by reference in their entirety, and are selectively referred to in the remainder of this disclosure by their accompanying reference numbers in square brackets (i.e., <4> for the fourth numbered paper by R. E. Bryant et al.):

<1> E. M. Clarke, O. Grumberg, and D. Peled, Model Checking: MIT Press, 1999.

<2> K. L. McMillan, Symbolic Model Checking: An Approach to the State Explosion Problem: Kluwer Academic Publishers, 1993.

<3> A. Biere, A. Cimatti, E. M. Clarke, and Y. Zhu, "Symbolic Model Checking without BDDs," in Proceedings of Workshop on Tools and Algorithms for Analysis and Construction of Systems (TACAS), vol. 1579, LNCS, 1999.

<4> R. E. Bryant, "Graph-based algorithms for Boolean function manipulation," IEEE Transactions on Computers, vol. C-35(8), pp. 677-691, 1986.

<5> M. Sheeran, S. Singh, and G. Stalmarck, "Checking Safety Properties using Induction and a SAT Solver," in Proceedings of Conference on Formal Methods in Computer-Aided Design, 2000.

<6> P. Ashar, M. Ganai, A. Gupta, Z. Yang, A. Mukaiyama, and K. Wakabayashi, "Formal Verification in an Industrial Setting: DiVer Verification Platform White Paper," NEC USA, CCRL 2001-C004-4-5509-1N, Dec 2001 2001.

<7> P. Ashar, P. Chauhan, M. Ganai, A. Gupta, Z. Yang, and L. Zhang, "DiVer Document: User Manual - Verification Platform for Digital Systems," NEC USA, CCRL 2001-C005-4-5509-2N, Dec 2001 2001.

<8> P. Ashar, P. Chauhan, M. Ganai, A. Gupta, Z. Yang, and L. Zhang, "DiVer Document: Tutorial - NEC production design case studies," NEC USA, CCRL 2001-C083-4-5509-5, Dec 2001 2001.

<9> H. Zhang, "SATO: An efficient propositional prover," in Proceedings of International Conference on Automated Deduction, vol. 1249, LNAI, 1997, pp. 272-275.

<10> M. Moskewicz, C. Madigan, Y. Zhao, L. Zhang, and S. Malik, "Chaff: Engineering an Efficient SAT Solver," in Proceedings of Design Automation Conference, 2001.

<11> P. Bjesse and K. Claessen, "SAT-based verification without state space traversal," in Proceedings of Conference on Formal Methods in Computer-Aided Design, 2000.

<12> M. Ganai and A. Aziz, "Improved SAT-based Bounded Reachability Analysis," in Proceedings of VLSI Design Conference, 2002.

<13> O. Shtrichman, "Tuning SAT Checkers for Bounded Model Checking," in Proceedings of International Conference on Computer-Aided Verification, 2000.

<14> O. Shtrichman, "Pruning Techniques for the SAT-based bounded model checking," in Proceedings of Workshop on Tools and Algorithms for the Analysis and Construction of Systems (TACAS), 2001.

<15> M. Ganai, L. Zhang, P. Ashar, and A. Gupta, "Combining Strengths of Circuit-based and CNF-based Algorithms for a High Performance SAT Solver," NEC USA, CCRL 2001-C079-4-5502-2, December 2001.

<16> A. Biere, A. Cimatti, E. M. Clarke, M. Fujita, and Y. Zhu, "Symbolic model checking using SAT procedures instead of BDDs," in Proceedings of the Design Automation Conference, 1999, pp. 317-320.

<17> A. Gupta, Z. Yang, P. Ashar, and A. Gupta, "SAT-based Image Computation with Application in Reachability Analysis," in Proceedings of Conference on Formal Methods in Computer-Aided Design, 2000, pp. 354-371.

<18> A. Gupta, A. E. Casavant, P. Ashar, X. G. Liu, A. Mukaiyama, and K. Wakabayashi, "Property-specific testbench generation for guided simulation," in Proceedings of VLSI Design Conference, 2002.

<19> J. Kim, J. Whittemore, J. P. M. Silva, and K. Sakallah, "Incremental Boolean Satisfiability and its application to delay fault testing," in Proceedings of International Workshop on Logic Synthesis, 1999.

<20> A. Kuehlmann and F. Krohm, "Equivalence Checking using Cuts and Heaps," in Proceedings of Design Automation Conference, 1997.

<21> M. Ganai and A. Kuehlmann, "On-the-fly compression of logical circuits," in Proceedings of International Workshop on Logic Synthesis, 2000.

<22> A. Kuehlmann, M. Ganai, and V. Paruthi, "Circuit-based Boolean Reasoning," in Proceedings of Design Automation Conference, 2001.

<23> P. Goel, "An implicit enumeration algorithm to generate tests for Combinational circuits," IEEE Transactions on Computers, vol. C-30, pp. 215-222, 1981.

<24> H. Fujiwara and T. Shimono, "On the Acceleration of Test Generation Algorithms," IEEE Transactions on Computers, vol. C-32, pp. 265-272, 1983.

<25> M. Schulz, E. Trischler, and T. Sarfert, "SOCRATES: A highly efficient ATPG System," IEEE Transactions on Computer-Aided Design of Integrated Circuits and Systems, vol. 7, pp. 126-137, 1988.

<26> M. N. Velev, "Benchmark Suites.http://www.ece.cmu.edu/~mvelev," October 2000.

<27> A. Gupta, A. Gupta, Z. Yang, and P. Ashar, "Dynamic detection and removal of inactive clauses in SAT with application in image computation," in Proceedings of Design Automation Conference, 2001.

<28> H. Cho, G. D. Hachtel, E. Macii, B. Plessier, and F. Somenzi, "Algorithms for approximate FSM traversal based on state space decomposition," IEEE Transactions on Computer-Aided Design of Integrated Circuits and Systems, vol. 15(12), pp. 1465-1478, 1996.

<29> I.-H. Moon, J.-Y. Jang, G. D. Hachtel, F. Somenzi, C. Pixley, and J. Yuan, "Approximate reachability don't-cares for CTL model checking," in Proceedings of the International Conference on Computer-Aided Design. San Jose, 1998.

<30> K. Ravi, K. L. McMillan, T. R. Shiple, and F. Somenzi, "Approximation and decomposition of Decision Diagrams," in Proceedings of the Design Automation Conference. San Francisco, 1998, pp. 445-450.

2. Introduction

### a) Model Checking

As hardware design complexity continues to rise, there is a greater need for effective verification methodologies in order to avoid costly errors. Formal verification techniques like symbolic model checking <1, 2> offer the potential of exhaustive coverage and the ability to detect subtle bugs in comparison to traditional techniques like simulation. However, these techniques do not scale very well in practice due to the state explosion problem. A recent alternative is the use of Bounded Model Checking (BMC) <3>. In contrast to symbolic model checking which is typically based on the use of Binary Decision Diagrams (BDDs) <4>, BMC is based on the use of Boolean Satisfiability (SAT) decision procedures. This allows it to handle much larger designs in practice, especially to find bugs when they exist.

In model checking, the hardware design is represented as a finite state machine, and the specification consists of a property expressed in temporal logic. The state space of the design is then exhaustively explored to check if it satisfies the specification. When it doesn't, a counterexample can typically be found, which demonstrates a violation of the correctness property. In bounded model checking, the focus is finding counterexamples (bugs) of a bounded length $k$. This avoids handling of infinite paths and fixpoint operations, and only paths of a bounded length k need to be considered. Effectively, the problem is translated to a propositional formula such that the formula is true if and only if there exists a counterexample of length $k$. In practice, the bound $k$ can be increased incrementally to find the shortest counterexample. In addition, a separate reasoning is needed to ensure completeness when no counterexample can be found up to a certain bound <3, 5>.

3. Background to the technology and related work

In this section, we discuss several aspects of related work, including background and conventional technologies for BMC.

The specification is expressed in LTL (Linear Temporal Logic), which includes the following temporal operators - the *next time* operator *X*, the *eventuality* operator *F*, the *globally* operator *G*, and the *until* operator *U*. To keep the discussion simple, formulas of the type *E f* are considered, where *E* is the existential path quantifier, and *f* is a temporal formula with no path quantifiers. The design is described as a standard *Kripke* structure $M = (S, I, T, L)$, with a finite set of states *S*, the set of initial states *I*, a transition relation between states *T*, and a labeling *L* of states with atomic propositions. Given a Kripke structure *M*, an LTL formula *f*, and a bound *k*, the translation task in BMC is to construct a propositional formula $<M, f>_k$, such that the formula is satisfiable if and only if there exists a witness of length *k* for the formula *f* in structure *M*.

Since the set of states is finite, a symbolic encoding in terms of Boolean variables denoted *s* is used to represent a state, and a sequence $s_0 \ldots s_k$ is used to represent a finite sequence of length *k*. The first set of constraints, $[M]_k$, is used to ensure that this sequence is a valid path in *M:*

$$[M]_k = I(s_0) \wedge \bigwedge_{i=0}^{i=k-1} T(s_i, s_{i+1})$$

The first part of this formula imposes the constraint that the first state in the sequence should be an initial state *I*, and the second part of this formula imposes the constraint that every successive pair of states should be related according to the transition 'relation *T*. Note that this second part corresponds to an unrolling of the sequential design for *k* steps, and results in an increasing SAT problem size with increasing *k*.

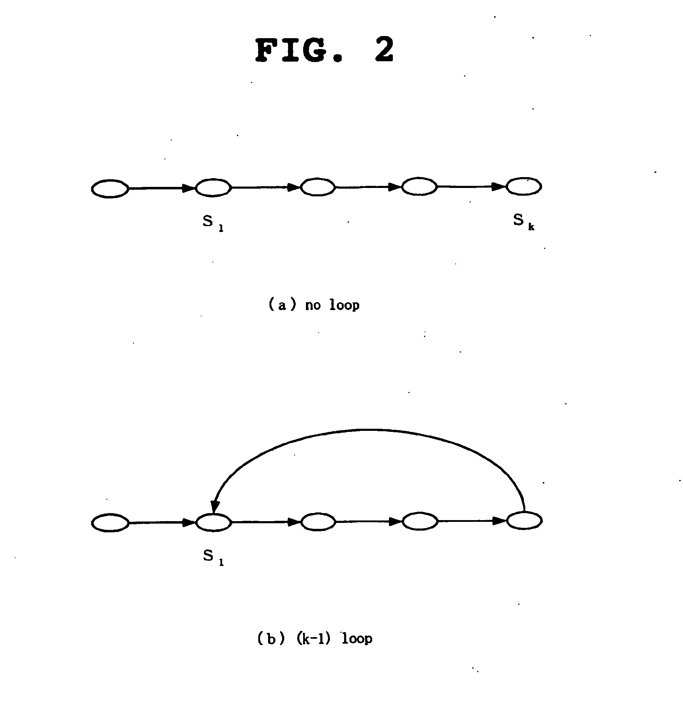

The next set of constraints ensures that this valid path in M satisfies the LTL formula *f*. This involves a case split, depending upon whether or not the path is a *(k, l)* -loop, as shown in FIG. 2 (from <3>). The case of a loop from state *k* to state *l* can be translated as $_lL_k = T(s_k, s_l)$. The case where there is no loop can be translated as $\neg L_k$, where $L_k = \bigvee_{l=0}^{l=k} {}_lL_k$. Let $[f]_k^0$ denote the translation for formula *f* in the no loop case, and $_l[f]_k^0$ denote the translation for *f* in the *(k, l)*-loop case (detailed definitions are in <3>). Finally, the *general translation* for the entire problem is given as follows:

$$[M, f]_k = [M]_k \wedge ((\neg L_k \wedge [f]_k^0) \vee (\bigvee_{l=0}^{l=k} ({}_lL_k \wedge {}_l[f]_k^0)))$$

Here the first conjunct refers to the requirement of a valid path, and the second conjunct refers to it satisfying the specification formula with the case split. For the discussion in this paper, it is important to note that this translation is monolithic, i.e. the entire formula is generated for a given *k*. This formula is then checked for satisfiability using standard SAT solvers, e.g. SATO <9>, Chaff <10>.

In practice, the search for longer witnesses is conducted by incrementing the bound *k*. This works well when a witness does exist. However, in case there is no witness, an additional proof technique is needed to conclude that the property is indeed false. In particular, it is sufficient to examine all *k* up to the diameter of the finite state machine <3>. Use of additional constraints such as loop-free paths, shortest paths etc. have also been proposed in a similar setting for proving safety properties <5, 11>.

Apart from finding bounded-length counterexamples, a BMC engine can also be used for performing proofs by induction<16>. Induction with increasing depth *k*, and restriction to loop-free paths, provides a complete proof technique for safety properties <5, 11>. Induction with depth k consists of the following two steps:

(a) Base case: to prove that the property holds on every *k*-length path starting from the initial state.

(b) Inductive step: to prove that if the property holds on a *k*-length path starting from any state, then it also holds on all its extensions to a *(k+1)*-length path.

The restriction to loop-free paths imposes the additional constraints that no two states in the paths are identical. Note that the base case includes use of the initial state constraint, but the inductive step does not. Therefore, the inductive step may include unreachable states also. In practice, this may not allow the induction proof to go through without the use of additional constraints, i.e. stronger induction invariants than the property itself. In particular, any circuit constraints known by the designers can be used to strengthen the induction invariants, including reachability constraints.

The above techniques are limited in their ability to operate on circuits with large number of gates and flip-flops. With increasing circuit size, these techniques rapidly become slow and also consume excessive memory.

US 6,324,694 B1 discloses model checking of hierarchical state machines. In particular, a conventional model checking of finite state machines are described with some specified improvements when dealing with hierarchical state machines. As mentioned before, such conventional forms of model checking of finite state machines are typically accomplished by using binary decision diagrams (BDD).

Further background art techniques are disclosed in:

| | |
|---|---|
| D2: | US 2002/178424 A1 (GUPTA AARTI ET AL) 28 November 2002 (2002-11-28) |
| D3: | EMERSON E A ET AL: "Modalities for model checking: branching time logic strikes back" SCIENCE OF COMPUTER PROGRAMMING, JUNE 1987, NETHERLANDS, Vol. 8, No. 3, 1987, pages 275 - 306, XP002270170 ISSN: 0167 - 6423 |

(continued)

| | |
|---|---|
| D9: BN: 0-7695-0543-0 | HAVERKORT B R ET AL: "On the use of model checking techniques for dependability evaluation" RELIABLE DISTRIBUTED SYSTEMS, 2000. SRDS-2000. PROCEEDINGS THE 19th IEEE SYMPOSIUM ON NURNBERG, GERMANY 16 - 18 Oct. 2000, LOS ALAMITOS, CA, USA, IEEE COMPUT. SOC, US, 10 October 2000 (2000-10-16), pages 228 - 237, XP010523963 IS |
| D10: | ABRAHAM J A ET AL: "Verifying properties using sequential ATPG" PROCEEDINGS INTERNATIONAL TEST CONFERENCE 2002, ITC 2002. BALTIMORE, MD, Oct. 7 - 10, 2002, INTERNATIONAL TEST CONFERENCE, NEW CORK, NY: IEEE, US, 7 October 2002 (2002-10-07), pages 194 - 202, XP010609742 ISBN: 0-7803-7542-4 |

## II. SUMMARY

A method for bounded model checking according to the invention and a corresponding program are defined in claims 1 and 30, respectively; the dependent claims are related to further developments of the invention.

The disclosed teachings are aimed at overcoming some of the disadvantages and solving some of the problems in relation to conventional technologies. There is provided a method for bounded model checking of arbitrary Linear Time Logic temporal properties. The method comprises translating properties associated with temporal operators F(p), G(p), U(p, q) and X(p) into property checking schemas comprising Boolean satisfiability checks, wherein F represents an eventuality operator, G represents a globally operator, U represents an until operator and X represents a next-time operator. The overall property is checked in a customized manner by repeated invocations of the property checking schemas for F(p), G(p), U(p, q), X(p) operators and standard handling of atomic propositions and Boolean operators.

In a specific enhancement, when a choice exists about which operator to check next, the choice is made according to priority determined by degree of difficulty of search.

Even more specifically, the degree of difficulty of search is estimated to be increasing in the following order: atomic propositions, X operator, F operator, U operator, G operator.

In another specific enhancement, a subset of property checking schemas perform a partitioning of a $k^{th}$ instance of a corresponding bounded model checking problem to break up a corresponding Boolean satisfiability problem into multiple smaller Boolean satisfiability subproblems.

Even more specifically, the partitioning is performed across operators, and for each operator both across time frames and within time frames.

Even more specifically the partitioning is targeted, wherever possible, to lead to incrementally related Boolean satisfiability subproblems.

Even more specifically, learning across Boolean satisfiability subproblems is used.

Even more specifically, an incremental formulation of a Boolean satisfiability algorithm is used to learn across related subproblems.

In another specific enhancement, circuit simplification based on constant propagation is used.

In another specific enhancement, circuit simplification based on detection of structural isomorphism is used.

In another specific enhancement, Boolean satisfiability checking problems are solved by using a hybrid SAT solver combining use of circuit-based and CNF-based satisfiability algorithms.

In another specific enhancement, the property checking schema for F(p) comprises starting search from a given start state at time frame i, with a given constraint database, wherein i=0 corresponds to an initial state. The satisfiability of p in the $i^{th}$ state of a current path is checked. If satisfiable, the search is terminated with success. If unsatisfiable, it is learnt that that p is always false in the $i^{th}$ state and this learnt knowledge is added to the constraint database. The search is continued by increasing i until some specified limit, and earlier steps are repeated. The search is terminated inconclusively if specified limit is reached.

In another specific enhancement, completeness is checked.

Even more specifically the checking for completeness further comprises) adding constraints to ensure that the transition out of the $i^{th}$ state does not visit a state seen earlier in the path, and checking satisfiability of the constraint database. If unsatisfiable, the search is terminated with failure. Otherwise search is continued. The steps are repeated until all previous states have been examined.

In another specific enhancement, the property checking schema for G(p) comprises starting search from a given start state at time frame i with a given constraint database, wherein i=0 corresponds to the initial state. A constraint is added to the database to ensure that p is satisfied in the $i^{th}$ state of the current path, and the satisfiability is checked. If unsatisfiable, the search is terminated with failure. if satisfiable, each $j^{th}$ state is checked from start state to $i^{th}$ state whether it is a loopback state and the search is terminated with success if a loopback state is found. Each $j^{th}$ state before the start state is checked whether it is a loopback state and the search is termianted with success if a loopback state is found. The search is continued by increasing i until some specified limit the steps are repeated. The search is termianted inconclusively if specified limit is reached.

In addition, there are several more specific enhancements for the method provided above, that should be clear from the presentation of claims and the detailed description.

Another aspect of the disclosed teachings is a method for inductive proof of safety properties expressed in Linear Time Temporal Logic comprising checking a k-instance base case on a negation of a given property, and checking a k-instance inductive step on a monitor predicate corresponding to the given property, starting from k=0 and increasing it up to a given specified limit, wherein the base case checking further comprises translating the negated property into property checking schemas consisting of Boolean satisfiability checks, associated with temporal operators F(p), and X(p), wherein F represents an eventuality operator, and X represents a next-time operator. A search is performed to find a witness of the negated property, starting from the initial state, by repeated invocations of the property checking schemas for F(p), X(p) operators and standard handling of atomic propositions and Boolean operators. The overall proof is terminated with success if it is proved that a witness cannot be found. The overall proof is terminated with failure if a witness is found in k time frames otherwise when it is inconclusive, the inductive step checking is continued wherein the inductive step checking consists of the following property checking schema. Constraints are added to ensure that the monitor predicate holds for k time frames starting from an arbitrary state, and it does not hold in the k+1$^{st}$ time frame. If unsatisfiable, the overall proof is terminated with success. Otherwise, the search is continued. The search is continued by increasing k up to the specified limit and repeating the base case and inductive step. The proof is inconclusive if the specified limit for k is reached.

Another aspect of the disclosed teachings is a verification engine for verification of circuits wherein the engine is capable of bounded model checking of arbitrary Linear Time Logic temporal properties. The engine comprises a property translator and a property checker. The property translator is adapted to translate properties associated with temporal operators F(p), G(p), U(p, q) and X(p) into property checking schemas comprising Boolean satisfiability checks, wherein F represents an eventuality operator, G represents a globally operator, U represents an until operator and X represents a next-time operator. The property checker is adapted to check an overall property in a customized manner by repeated invocations of the property checking schemas for F(p), G(p), U(p, q), X(p) operators and standard handling of atomic propositions and Boolean operators.

Another aspect of the disclosed teachings is an inductive proof engine for circuits wherein the engine is capable of proving safety properties in Linear Time Logic temporal properties. The engine comprises a base case checker adapted to check a k-instance base case on a negation of a given property. An inductive step checker is provided that is adapted to check a k-instance inductive step on a monitor predicate corresponding to the given property. A property translator is provided that is adapted to translate negated properties into property checking schemas consisting of Boolean satisfiability checks, associated with temporal operators F(p) and X(p), wherein F represents an eventuality operator and X represents a next-time operator; and a searcher is provided that is adapted to search for a witness of the negated property.

Still another aspect of the disclosed teachings is an inductive proof engine for circuits wherein the engine is capable of proving safety properties in Linear Time Logic temporal properties. The engine comprises a base case checker adapted to check a k-instance base case on a negation of a given property. An inductive step checker is provided that is adapted to check a k-instance inductive step on a monitor predicate corresponding to the given property. A property translator is provided that is adapted to translate negated properties into property checking schemas consisting of Boolean satisfiability checks, associated with temporal operators F(p) and X(p), wherein F represents an eventuality operator and X represents a next-time operator. A searcher is provided that is adapted to search for a witness of the negated property.

More specific enhancements for the various specific enhancements are also provided, as should be clear from the claims as well as from the detailed description.

## III. BRIEF DESCRIPTION OF THE DRAWINGS

The above objectives and advantages of the disclosed teachings will become more apparent by describing in detail preferred embodiments thereof with reference to the attached drawings in which:

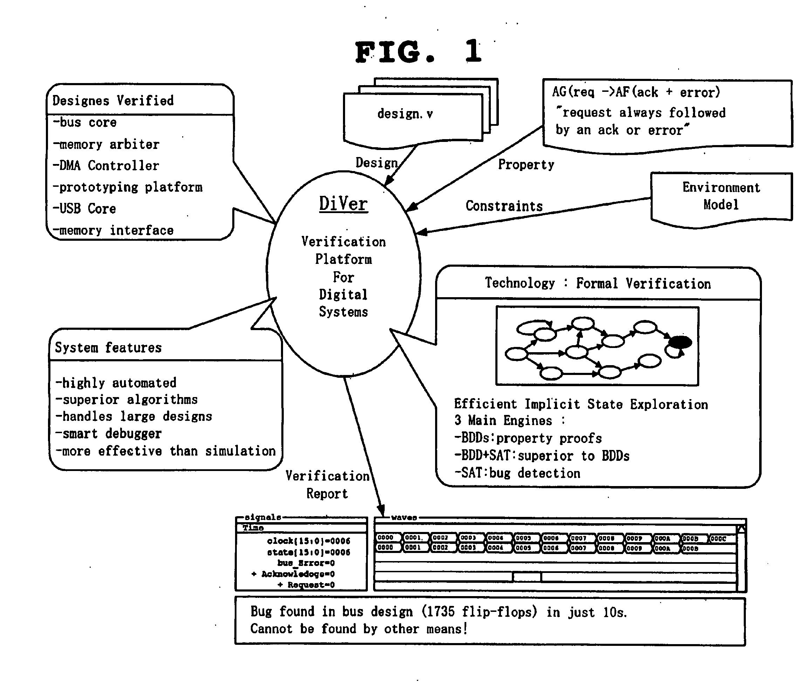

FIG. 1 shows a schematic for a verification platform that depicts the functionalities included in a BMC system.

FIG. 2(a)-(b) depicts a case split for a bounded path with no loop and a (k-l) loop.

FIG. 3 shows a pseudo-code for an implementation of a circuit-based BCP procedure

FIG. 4 shows a 2-input AND Lookup Table for Fast Implication Propagation.

FIG. 5 shows Table 1 that depicts Boolean Constraint Propagation (BCP) time per million implications.

FIG. 6 shows Table 2 that depicts SAT run times for comparison.

FIG. 7 shows Table 3 that depicts SAT run times a hybrid solver enhances with heuristics.

FIG. 8(a)-(b) shows an example of counting literals in clauses.

FIG. 9 shows Table 4 that shows results for BMC Verification.

FIG. 10 shows Table 5 that depicts results of proof by induction examples without reachability constraints.

FIG. 11 shows Table 6 that depicts results for proof by induction examples with reachability constraints.

## IV. DETAILED DESCRIPTION

### IV.A. Customized Property Translation

In this section, the customized translations that form part of the disclosed teachings are described. Rather than generating a monolithic SAT formula, the translation schemas can be viewed as building the formula incrementally, by lazily indexing over the bounded conjunctions/disjunctions, terminating early when possible. Broadly, an incremental formulation is used, employing learning and partitioning to generate multiple simpler SAT subproblems.

Optionally, additional constraints are used to focus only on loop-free path skeletons, i.e. where all states on the path are distinct pair-wise. For safety properties, this has been used to ensure completeness of proofs <5, 11>. In the translation schemas, they are used for liveness properties, which require a witness with a loop. For example, consider the property $G(p)$. Loop-free path skeletons are focussed on where $p$ is true in each state, and all states but the last one on the path are distinct. The last state is identical to the $l^{th}$ state on the path, called the loopback state, to form a $(k,l)$-loop.

Clearly, any witness for $G(p)$ has a loop-free skeleton, which is found by systematically increasing the bound $k$. For a given $k$, the search for a loopback state can start from either the initial or the $k^{th}$ state. If it is found, the property is true. However, if all loop-free skeletons have been examined without finding a loopback state, then the property is false. Recall that the general translation for the $G(p)$ property also considers $(k, l)$-loops with increasing $k$. However, it does not constrain the path skeletons to be loop-free. Though loop-free path skeletons do not give as tight a bound as sequential diameter of the design, they do provide a proof capability within the scope of a SAT solver. In contrast, reasoning about the sequential diameter requires a QBF (Quantified Boolean Logic) solver.

Before the details are described, it is useful to classify the different types of constraints that define the SAT subproblems generated by the disclosed translation schemas. They are:

- Circuit constraints

  - ■ Constraints due to the property subformulas
  - ■ Constraints learned from unsatisfiable SAT instances
  - ■ Loop-check constraints for considering only loop-free path skeletons

Note that the general translation uses only the first two types of constraints, i.e. circuit and property constraints. Individual use of learned constraints <12>, and loop-check constraints <5>, have been known conventionally, but only in the context of verifying simple safety properties. Note also that another type of constraints - those arising from conflict clause - are typically generated by the SAT solver itself. By using an incremental formulation, the disclosed translation schemes facilitate the sharing of such constraints also.

To highlight the partitioning, learning, and incremental aspects of the disclosed customized property translations, an exemplary but non-limiting, pseudo code for handling common LTL properties is included herein. Here, $p$ and $q$ denote any Boolean combination of propositional formulas and the $X$ operator, each associated with a node in the circuit graph representation; $is\_sat(C)$ denotes a call to the SAT solver, which returns true if and only if the Boolean formula $C$ is satisfiable; $L\_ij$ denotes that there is a loop transition between the $i^{th}$ and $j^{th}$ time frames, i.e. $L\_ij = T(s_i, s_j)$; and $N$ denotes the maximum depth of unrolling which is under user's control. For ease of description, the circuit constraints are not shown in these translations - they are always added to the SAT subproblems.

As an example, consider the translation of $F(p)$. Note that the outer for-loop on index $i$ (line 13) corresponds to incrementing the bound $k$ for BMC, up to the user-specified maximum limit $N$. It incrementally builds up the clause database $C$, which is initially true (line 8). For each $i$, the satisfiability of $(C \& f\_i)$ is checked (on line 14), i.e. if the current clause database is satisfiable while $p$ is true in the current time frame. If satisfiable, the witness for $F(p)$ is found, and a true is returned. If not, then the fact that $p$ is always false in time frame $i$ is *learned* and added to the clause database $C$ (line 15). The inner for-loop on index $j$ (lines 16—21) is optional, and is used selectively to perform proofs. It adds pair-wise constraints to $C$ in order to ensure that there is no loop from current state $s_i$ to any previous state $s_j$ on the path. Then a SAT check is made on $C$ (line 21). If $C$ is unsatisfiable, it can be concluded that the property is false because all loop-free paths have been examined without finding $p$ to be true in any time frame. This provides the *completeness* argument for $F(p)$. On the other hand, if $C$ is satisfiable, there is a way to extend the current path such that it remains loop-free, and another iteration is performed by incrementing loop index $i$. As a further optimization, pair-wise loop constraints are added *incrementally*, as shown in the commented out line 19. This can provide early termination in some cases, without necessarily adding all constraints.

It is also interesting to see how the loop constraints are handled for the property $G(p)$, which requires a witness with a loop. Again, the outer for-loop on i corresponds to incrementing the bound $k$ for BMC. The procedure is started by checking satisfiability of $(C\ \&\ p\_i)$. If it is unsatisfiable, clearly there is no way to satisfy $p$ in the current time frame $i$, and the $G(p)$ property is false. If it is satisfiable, the constraints are added to check if there is a loop transition from the current state $s_i$ to a previous state $s_j$ on this path. Note that this is checked incrementally (line 35) so that the procedure can be terminated the first time that such a loop is found. However, if such a loop is not found, this fact is learned and added to the clause database $C$ (line 36). After all the loop constraints have been added, a completeness check is made (line 38), which either allows a conclusion that the property is false, or extends the loop-free path skeleton for the next iteration. Pseudo-code for common LTL properties is shown below.

```
1  /* N = Max depth
2    f_i = property node at i^th time-frame
3    L_ij = Loop constraint between the i^th
4        and j^th time frames
5    &(|) = cnf conjunction(disjunction) */
6
7  F(p){
8    F(1,p,0);
```

```
9  }

10

11  F(IC,p,start){

12    C = IC;

13    for(i=start;i<N;i++) {

14      if (is_sat(C & p_i)) return true;

15      C = C & !p_i;

16      for(j=i;j>=start;j--) { //optional 16-21

17        C = C & !L_ij;

18        // optional 19

19        // if(!is_sat(C))return false;

20      }

21      if (!is_sat(C)) return false;

22    }

23  }

24

25  G(p){

30    C = 1;

31    for (i=0;i<N;i++) {

32      C = C & p_i;

33      if (!is_sat(C)) return false;

34      for(j=i;j>=0;j--) {
```

```
35      if (is_sat(C & L_ij)) return true;
36        C = C & !L_ij;
37      }
38      if (!is_sat(C)) return false;
39    }
40  }
41
42  G(IC,p,start){
43    C = IC; t = 0; C"= 1;
44    for (i=start;i<N;i++) {
45      C = C & p_i;
46      if (!is_sat(C)) return false;
47      for(j=i;j>=start;j--) {
48        if (is_sat(C & L_ij)) return true;
49        C = C & !L_ij;
50      }
51      C' = C & C";
52      for(j=start-1;j>=t;j--) {
53        if (!is_sat(C' & p_j)) {
54          t = j+1; C" = C" & !p_j; break; }
55        C' = C' & p_j;
56        if (is_sat(C'& L_ij)) return true;
```

```
57    C' = C' & !L_ij;

58    }

59    for(l=start-1;l>j;l--)

60      C = C & !L_il;

61    if (!is_sat(C)) return false;

62  }

63 }

64

65 F(p or F(q)) {

66  C = 1;

67  for(i=0;i<N;i++) {

68    if (is_sat(C & p_i)) return true;

69    C = C & !p_i;

70

71    if (F(C,q,i)) return true;

72

73    for(j=i;j>=0;j--) {

74      C = C & !L_ij;

75      //if (!is_sat(C)) return false;

76    }

77    // reached the bound

78    if (!is_sat(C)) return false;
```

```
79   }

80 }

81

82 F(p and F(q)){

83   C = 1;

84   for(i=0;i<N;i++) {

85     if (!is_sat(C & p_i)) {

86       C = C & !p_i;

87     } else {

88       if (F(C & p_i,q,i)) return true;

89     }

90     for(j=i;j>=0;j--) {

91       C = C & !L_ij;

92       //if (!is_sat(C)) return false;

93     }

94     // reached the bound

95     if (!is_sat(C)) return false;

96   }

97 }

98

99 F(p or G(q)){

100   C = 1;
```

```
101  for(i=0;i<N;i++) {
102    if (is_sat(C & p_i)) return true;
103    C = C & !p_i;
104
105    if (G(C,q,i)) return true;
106
107    for(j=i;j>=0;j--) {
108      C = C & !L_ij;
109      //if (!is_sat(C)) return false;
110    }
111    // reached the bound
112    if (!is_sat(C)) return false;
113  }
114 }
115
116 F(p and G(q)){
117  C = 1;
118  for(i=0;i<N;i++) {
119    if (!is_sat(C & p_i)) {
120      C = C & !p_i;
121    } else {
122      if (G(C & p_i,q,i)) return true;
```

```
123   }

124   for(j=i;j>=0;j--) {

125     C = C & !L_ij;

126     //if (!is_sat(C)) return false;

127   }

128   // reached the bound

129   if (!is_sat(C)) return false;

130 }

131 }

132

133 U(IC,q,r,start) {

134 C = IC;

135 for(i=start;i<N;i++) {

136   if (is_sat(C & r_i)) return true;

137   C = C & !r_i & q;

138   if (!is_sat(C)) return false;

139   for(j=i;j>=0;j--) {

140     C = C & !L_ji;

141     //if (!is_sat(C)) return false;

142   }

143   // reached the bound

144   if (!is_sat(C)) return false;
```

```
145  }

146 }

147

148 F(p and U(q,r)) {

149  C = 1;

150  for(i=0;i<N;i++) {

151    if (!is_sat(C & p_i)) {

152    C = C & !p_i;

153  } else {

154    if (U(C & p_i, q, r,i)) return true;

155  }

156  for(j=i;j>=0;j--) {

157    C = C & !L_ji;

158    //if (!is_sat(C)) return false;

159  }

160    // reached the bound

161    if (!is_sat(C)) return false;

162  }

163 }

164

165 F(p or U(q,r)) {

166  C = 1;
```

```
167  for(i=0;i<N;i++) {
168    if (is_sat(C & p_i)) return true;
169    C = C & !p_i;
170    if (U(C, q, r,i)) return true;
171    for(j=i;j>=0;j--) {
172      C = C & !L_ji;
173      //if (!is_sat(C)) return false;
174    }
175    // reached the bound
176    if (!is_sat(C)) return false;
177  }
178 }
```

Nested properties like *F(p and G(q))* provide the opportunity to partition further into the constituent *F* and *G* subformulas allowing learning across the partition. For *F(p and G(q))*, in particular, an exemplary non-limiting algorithm is as follows: The outer loop on *i* (line 118) increments the bound *k* for BMC. The first SAT subproblem is to check (*C & p_i*). If it is false, then $!_{p\_i}$ is learned and added to *C* (line 120). In this case, if the current path cannot be extended to remain loop-free (lines 124-128), the property is proved to be false. On the other hand, if *(C & p_i)* is true, the algorithm moves on to checking *G(q),* starting from time frame *i*.

This check is performed by the function call *G(C & p_i, q, i),* which looks for a path starting at $s_i$, such that *q* is true at each state in the path, and the path loops back to a previous state. Note that *G(C & p_i, q, i)* also checks for a loopback state at time frame *j* less than *i* (lines 52-58). In this case, it must additionally prove that *q* is true at each state until $s_i$. If it is found to be unsatisfiable at any such time frame *j*, $!q\_j$ is learned (line 54). Note the large number of SAT calls made in the process of analyzing this property, and how the databases (*C, C', C"*) are incremented between successive calls. Each such SAT call that is found to be unsatisfiable provides an opportunity to learn a new constraint. The analysis of such properties is much faster with our approach than with the general translation.

The remaining properties shown in the pseudo-code, as well as other LTL properties that might be found useful, are handled in a similar fashion. The features of the technique include exploiting partitioning, learning, incremental SAT checking, wherever possible. Optionally, loop check constraints can also be added for proof completeness.

1. Extending Scope of Correctness Properties

Not all interesting correctness properties can be expressed in LTL. For example, for one of the production designs, the designers wanted to use the specification *AG (p -> EX q)* to check the feasibility of a certain transition out of a particular state. Though this cannot be expressed as an LTL property, it is possible to handle it within the SAT-based BMC framework.

A more general case of using any bounded number of *EX* operators (denoted *EX:n*) is also shown in pseudo-code herein. As a nonlimiting example, consider the first translation (the second translation is similar). It can be used to obtain a counterexample for the property discussed above, since it looks for a witness for the negated property *EF (p & !(EX q)).* Note that LTL semantics, where *!(EX q)* would be the same as *EX !q,* are not used here. Rather CTL semantics are used, where *!(EX q) = AX !q.* It is easy to handle *n* number of *X* operators by unrolling forward the sequential design for *n* more steps, and creating a circuit node corresponding to *X:n q*, denoted $q_{\{n+i\}}$. Pseudo code for common non-LTL properties is shown below:

```
1  EF(p and ! EX:n q){
2     C = 1; C' = 0;
3     for (i=0;i<N;i++) {
```
.

```
4    if (!is_sat(C & p_i)) {
5      C = C & !p_i;
6    } else {
7      if (!is_sat(C & p_i & q_{n+i}))
8        return true;
9      else {
10       // exclude states with p & q_{n+i}
11       while(1) {
12         C' = C'| get_sat_state_cube(i);
13         if (!is_sat(C& !C'& p_i))
14           break; // no more p_i states
15         if (!is_sat(C& !C'& p_i & q_{n+i}))
16           return true; // found witness
17       } // end of while loop
18     }
19   }
20   for(j=i;j>=0;j--) {
21     C = C & !L_ij;
22     //if (!is_sat(C)) return false;
23   }
24   if (!is_sat(C)) return false;
25 }
```

```
26 }

27

28 EF(p or ! EX:n q){

29   C = 1;

30   for (i=0;i<N;i++) {

31     if (is_sat(C & p_i)) return true;

32     else {

33       C = C & !p_i;

34       if (!is_sat(C & q_{n+i})) return true;

35       else {

36         // exclude states with q_{n+i}

37         while(1) {

38           C' = C'| get_sat_state_cube(i);

39           if (!is_sat(C& !C')

40             break; // no more states

41           if (!is_sat(C& !C'& q_{n+i}))

42             return true; // found witness

43         } // end of while loop

44       }

45     }

46   for(j=i;j>=0;j--) {

47     C = C & !L_ij;
```

```
48      //if (!is_sat(C)) return false;

49   }

50   if (!is_sat(C)) return false;

51  }

52 }
```

The procedure checks to see whether $p\_i$ is satisfiable (line 4). If it is not, $!p\_i$ (line 5) is learnt and $i$ is incremented. If it is satisfiable, the procedure checks whether any such state also satisfies $q\_{n+i}$ (line 7). If there is no way to also satisfy $q\_{n+i}$, the witness is deemed to have been found (line 8). On the other hand, if it is satisfiable, those states that satisfy both $p\_i$ and $q\_{n+i}$ to be excluded from our consideration. This is done by the while loop (lines 11-17). Each iteration of the loop updates the exclusion set $C'$ (initialized to be empty) by adding to it the satisfying state cubes, i.e. states that satisfy both $p\_i$ and $q\_{n+i}$ (line 16). Next, it is checked if there are any states other than $C'$ that satisfy $p\_i$ (line 13). If no such state exists, the procedure has to break from the while loop, and increment $i$ to look for a longer witness (line 14). However, if such a state does exist, it is checked whether it can additionally satisfy $q\_{n+i}$ (line 15). If it cannot, a witness is deemed to have been found. Otherwise, the while loop is executed to exclude such states again. For completeness, the procedure can optionally focus on loop-free skeletons only (lines 20-24).

Note that here the SAT solver is being used to *incrementally* enumerate the solutions for $(p\_i$ & $q\_{n+i})$ in the exclusion set. A combination of SAT and BDDs can also be used to compute image sets <17>, and they can be used as constraints within the SAT-based BMC framework.

Another useful CTL property we have encountered is $AG(p \to EF\ q)$, which can be used to check resetability, absence of deadlock etc. Due to the alternation, and the fixpoint nature of the nested $EF$ operator, it is not possible to check this property within the SAT-based BMC framework. However, in practice, designers do have a bound in mind when checking for the eventual reachability of the desired state where $q$ is true. In such cases, the $EX{:}n$ operator with increasing $n$, serves as a bounded approximation for the $EF$ operator.

It is possible, in principle, to extend the scope of correctness properties to cover all CTL modalities. The tricky issues are handling alternation, and keeping track of a *witness graph,* rather than a witness path. In general, this may require use of a QBF solver, or some combination of SAT and BDDs.

2. Incremental SAT Techniques

As described in the previous sections, BMC involves solving a series of SAT instances corresponding to problems with increasing bound $k$. Several researchers <13, 19> have observed that conflict clauses can be shared between two or more SAT instances with a non-empty intersection between their clause sets, which can lead to an overall reduction in SAT solving time. Specifically, there is considerable overlap of circuit constraints between a $k$-instance and a $k+1$-instance of the BMC problem, since they share $k$ unrollings of the transition relation. This has been exploited using a constraint sharing technique which reuses constraints deduced while checking the $k$-instance of the problem, for speeding up the $k+1$- instance <13, 14>, thereby leading to a reduction in the overall verification time.

In the exemplary BMC implementation discussed in this disclosure, sharing occurs not just between the circuit constraints due to the unrolled transition relation, but also between the constraints arising from the property translations. Furthermore, multiple SAT problems are generated not only when increasing the bound k, but even within a single $k$-instance due to use of partitioning in our translation schemas which add constraints incrementally (described in Section IV A). This focus on constraint sharing across multiple SAT instances leads to a potential reduction in the overall verification time by using incremental SAT techniques.

The basic constraint sharing technique in a SAT solver works as follows <14>. Given two SAT instances $S\_1$ and $S\_2$, conflict clauses that are deduced solely from the set of common clauses $Y\_0$ (i.e., clauses that are in both $S\_1$ and $S\_2$) are identified. Identification is based on first marking the $Y\_0$ clauses. Then, for every conflict clause generated by a conflict analysis, if all clauses leading to the conflict are marked, then the conflict clause is also marked.

In the exemplary implementation, each clause has a bit vector field, called *gflag*. Each bit of *gflag* denotes whether the clause belongs to the group corresponding to that bit position. Furthermore, clauses are classified into three types -- a constraint clause, a circuit clause, or a conflict clause. A constraint clause belongs to at most one group. A circuit clause does not belong to any group. A conflict clause that is added during conflict analysis becomes a member of a group if there exists any clause leading to the conflict that belongs to that group. Note that conflict clauses derived only from circuit clauses (which include the initial state constraint) can always be reused, though not necessarily replicated.

A small example of using incremental SAT techniques for proving the *EF(p)* property is shown herein. At the $i^{th}$ time frame, the constraint clause *(p_i=1)* is added to a new group, *gid*. (Recall that $p\_i$ is property node *p* at the $i^{th}$ time frame). After an UNSAT result, this clause group gid is deleted, since it will not be reused in later time frames. With this deletion, all conflict clauses and constraint clauses that are members of the group *gid* are removed. However, conflict clauses that are deduced only from the circuit clauses still remain, and can be shared across the time frames. Furthermore, due to an UNSAT result, we use global learning to add the clause *(p_i=0)* to the clause group *root_gid*. Any conflict clause deduced from such globally learned clauses can also be reused in later time frames. Following is a pseudo-code showing the use of Incremental SAT techniques.

.

```
// N = Max depth

// p_i = property node at i-th time-frame

            .
        .

EF(p)

{
```

```
// allocate a group for learned clauses

root_gid = alloc_group_id();

for(i=0;i<N;i++) {

    // allocate a new group id

    gid = alloc_group_id();

    // add the (p_i = 1) as constraint clause to

    // the group, gid.

    add_constraint(p_i,gid);

    status = sat_solve();

    if (status == SAT) return true;

    // delete conflict and constraint clauses

    // that belong to the group gid. Note that

    // conflict clauses derived only from the

    // circuit clauses are never deleted.

    delete_group_id(gid);

    // add the learned clause (p_i=0) to the

    // group root_gid.

    add_constraint(!p_i,root_gid);

}

}
```

A similar modification is used with translations of other properties as well, in order to exploit incremental SAT techniques for conflict clauses and learned constraint clauses.

3. Circuit Simplification

In the exemplary BMC implementation discussed, circuit simplification techniques are used during pre-processing, as well as during the course of property checking when unrolling the transition relation of the design. The motivation is to simplify the generated SAT problems in order to reduce the overall verification time. Furthermore, circuit simplification techniques were found to be more efficient in handling of constants, in comparison to constant propagation within CNF-based SAT decision procedures. Such constants arise due to initial state and environmental constraints involving constant values on flip-flops, and learned constant constraints added during property checking.

Circuit simplification is achieved by using a non-canonical two-input AND/INVERTER graph representation <20>, and an on-the-fly reduction algorithm <21, 22> on such a graph representation. This graph is used to represent both the design and the Boolean functions computed during symbolic computation across time frames. On the negative side, an AND/INVERTER graph is non-canonical, unlike a BDD which is canonical. However, on the positive side, its size is far less sensitive to any particular function or the variable ordering, and it is often more succinct than a BDD.

The on-the-fly-reduction algorithm is based on an efficient functional hashing scheme for representing such graphs. Similar to BDDs, a hash table is used to remove structural redundancy during construction. Further, a structural two-level lookup scheme is applied that converts any local four-input substructure into a canonical representation, effectively removing local redundancy. If the local two-level lookup does not apply, simple rewriting is used to further reduce the circuit graph (details are available <22>). Effectively, this identifies a large number of isomorphic substructures and maps them onto the same subgraph, thereby achieving significant compression of the graph. Intuitively, this simplified graph reduces the search space for a SAT-solver and hence, is more efficient for Boolean reasoning. As shown in its application to bounded reachability analysis <12>, the computational advantage gained by SAT due to such simplification is significant.

### 4. Hybrid SAT Solver

A hybrid SAT solver is used in the disclosed exemplary BMC engine. It employs state-of-art innovations in decision variable selection, BCP and backtracking, while processing the original logic formula in circuit form, and learned conflict clauses in CNF, respectively. In particular, important differences in key steps of the circuit-based and CNF-based approaches for SAT are discussed as well as how benefits are realized from both in the hybrid approach.

### a) State-of-Art in Circuit-Based BCP

BCP is found to be a part of a SAT solver that constitutes about 80% of the total time in many instances. Therefore, any improvement in BCP significantly benefits the overall performance of a SAT solver.

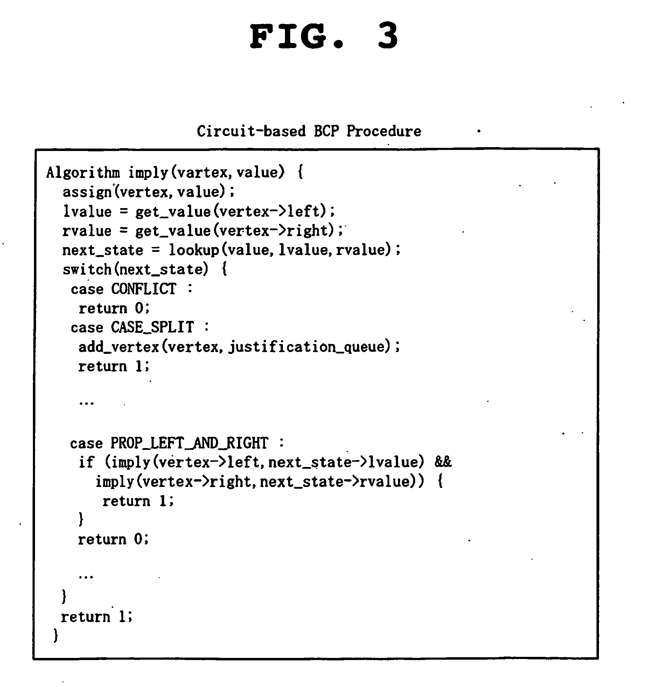

Existing circuit-based Boolean reasoning implementations <22-25> use a representation based on AND and OR gate vertices with INVERTERs either as separate vertices or as attributes on the gate inputs. Constant propagation across AND and OR gates is, of course, well known, but the speed tends to be very implementation dependent. As an example, <22> uses a lookup table for fast implication propagation. Based on the current values of the inputs and output of the vertex, the lookup table determines the next "state" of the gate where the state encapsulates any implied values and the next action to be taken for the vertex. The algorithm **imply** from<22> shown in FIG. 3 for a generic vertex type iterates over the circuit graph.

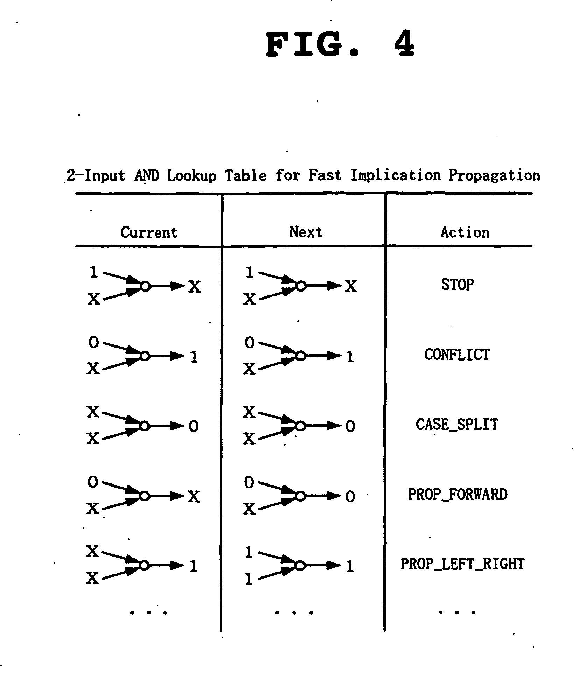

For each vertex, it determines new implied values and the direction for further processing. FIG. 4 (from <22>) gives some cases from the implication lookup table for a two-input AND gate as an example. For Boolean logic, only one case, a logical 0 at the output of an AND vertex, requires a new case split to be scheduled in the *justification_queue*. All other cases either cause a conflict, in which case the algorithm returns for backtracking, or further implications, or a return to process the next element from the *justification_queue*. Due to its low overhead, this implication algorithm is highly efficient. As an indication, on a 750 MHz Intel PIII with 256 MB, it can execute over one million implications per second.

### 1. Comparison with CNF-Based BCP

The CNF-based BCP in Chaff <10> relies on *2-literal* watching and *lazy-update* for efficiency. This approach has a clear advantage when clauses are large since unnecessary traversal of such clauses is avoided. To reduce overhead, this approach does not keep track of the clauses that have been satisfied. However, there is an inherent cost associated with visiting the satisfied clauses. Specifically, even if a clause gets satisfied due to an assignment to some un-watched literal, this approach will still update the watched literal pointers. In addition, there is an inherent overhead built into the translation of gates into clauses. Each two-input gate translates to three clauses, while in the circuit-based approach a gate is a monolithic entity. Therefore, in the circuit approach an implication across a gate requires a single look up in the table of FIG. 4 while in the CNF approach it requires processing multiple clauses.

For the generally small clauses arising from circuit gates it is found that these differences translate to significant differences in BCP time. As is shown in the next section, BCP on a gate representation is consistently and significantly faster than BCP in a state-of-art CNF based solver like Chaff.

### b) Effect of Conflict-Based Learning Motivates the Hybrid Approach

When clauses are large on the other hand, as in the case of conflict-based learnt clauses, adding them as a gate tree for circuit-based BCP can lead to an excessively large learned structure. Addition of such gate tree results in a significant increase in the size of the circuit. This in turn, increases the number of implications, and thereby, negates the gains obtained from BCP on the circuit structure. For such clauses, it is more appropriate to maintain them as monolithic clauses and take advantage of CNF-based 2-literal watching and lazy update to process them efficiently.
Based on these observations, a hybrid approach is contemplated where the circuit-based logic expressions are maintained using the uniform-gate data structure, the learnt clauses as CNF and processed separately as appropriate.

### c) BCP Results

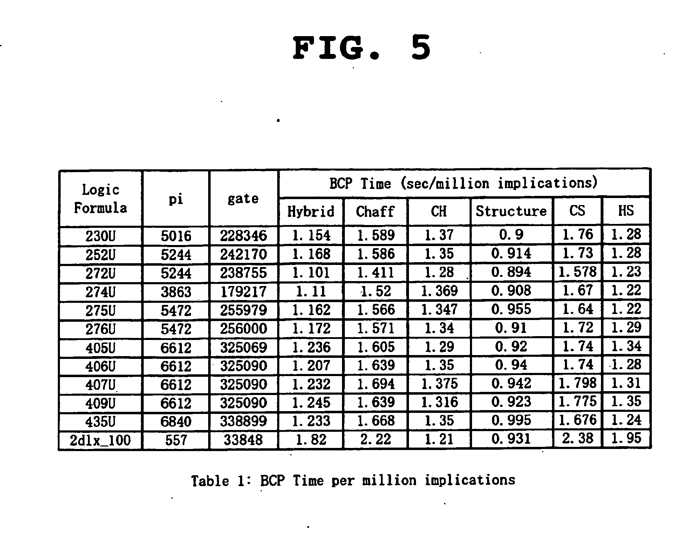

The times presented in Table 1 (shown in FIG.5) are the BCP times in seconds *per million implications* on a 750 MHz Intel PIII with 256 MB. The examples used are large logic formulas derived from the BMC application on a large industrial circuit. The times are for the hybrid and CNF approaches for exactly the same logic formula in the columns Hybrid and Chaff. The BCP time includes the time for BCP on learnt clauses added during the SAT process as well as the original gate clauses. The size of the formula in terms of the number of primary inputs and gates is indicated in the columns pi and gate. The column CH is the ratio between the CNF and hybrid BCP times. It is clear that the hybrid approach is consistently faster than the CNF-based approach in Chaff on these large formulas.
To demonstrate the overhead of BCP on learnt clauses, the BCP time *per million implications* is also presented with the circuit-based method on just the gate clauses in the same formulas. This is shown in the column Structure. The column CS (HS) is the ratio between the Chaff (Hybrid) time and the Structure time. These columns (CS and HS) allow us to compare the BCP time for just the gate clauses with the BCP time for the gate and learnt clauses. Clearly, large learnt clauses introduce a significant overhead on BCP time.

### d) Overall Hybrid SAT Solver

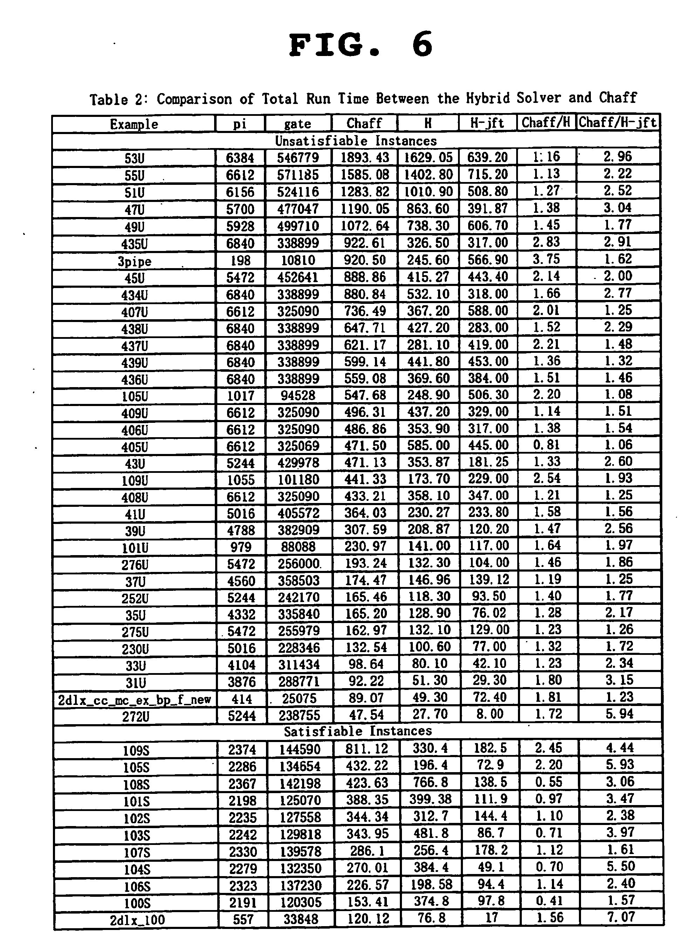

Demonstrating a faster BCP is only the partial story. It must also be demonstrated that the entire SAT process runs faster with the hybrid approach. Once a hybrid approach is used, a number of new circuit-based heuristics and advantages opened up that are unavailable in the pure CNF approach. In this section the benefits derived from them are discussed. The SAT run times are presented in Table 2 (shown in FIG.6) for this comparison. The times are on a 750 MHz Intel PIII with 256 MB. The logic formulas are derived from the application of BMC on three large industrial circuits (bus, arbiter, and controller) and some public domain benchmarks <26>. In order not to pollute the results, we ran the hybrid approach on more than 70 logic formulas, but report results only on those requiring more than 40s of CPU time. The formulas are distributed between unsatisfiable and satisfiable instances. The size of the formula can be determined from the pi and gate columns indicating the number of primary inputs and gates.

### e) Comparison of Chaff and Hybrid for Identical Heuristics

The first comparison is between the hybrid solver and Chaff for exactly the same heuristics, i.e., apart from the BCP differences, the two use identical algorithms for order of processing of implications, conflict-based learning, backtracking and decision variable selection. In spite of the same heuristics, a minor difference does creep in due to uncontrolled choice of the conflict node when several nodes are in conflict. This difference has a very little effect in unsatisfiable instances since the entire search space must always be traversed, but may have a pronounced effect in satisfiable instances for which one of the two solvers may happen to get lucky in hitting upon a solution early. With this in mind, only the unsatisfiable instances should be considered as reasonable data for this controlled experiment. The columns Chaff and H indicate the times for the Chaff and hybrid solvers in Table 2. It is clear that the overall performance of the hybrid solver is much better than Chaff. The typical ratio of Chaff time to Hybrid time is greater than 1.3 with the maximum being 3.75. The ratio of the total time spent in Chaff to the total time spent in the hybrid solver for all the unsatisfiable instances is 1.48. As expected, for the satisfiable instances shown in Table 2, Chaff to Hybrid ratio (Chaff / H) is distributed evenly on either side of 1.0 with a large standard deviation.

### 5. Circuit-Based SAT Heuristics

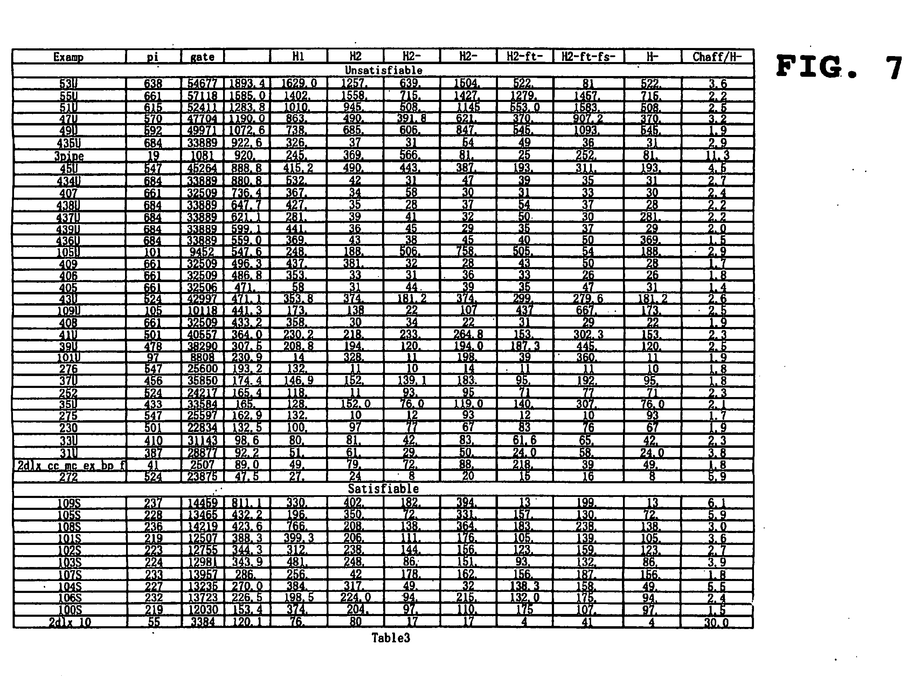

In this section details of the circuit-based heuristics used to enhance the hybrid solver are presented. Please consider Table 3 (shown in FIG.7) for the purpose. The same examples as in Table 2 are used here. The column H1 shows the run time for the hybrid solver with the same heuristics as in Chaff, as described in the previous section.

### a) Order of Following Implications

Chaff uses a FIFO mechanism to follow implications - basically the implications are processed in the order in which they are generated. With the knowledge of gate fanouts and directionality in the hybrid approach, it is possible to follow implications based on circuit paths. It is found that an approach in which the implications generated from gates are followed in FIFO manner, while the implications generated from the learnt clauses are followed in a path-based manner works very well. The column H2 indicates the total run time using this heuristic. It is clear that the heuristic generates a speed up over H1 for almost all (14 out of 18) the examples. All the columns to the right of H2 use this heuristic.

### b) Branch-Variable Decision Strategy

The decision strategy involves picking an unassigned variable and value to branch on. Several strategies have been suggested but none has been a clear winner. The most successful have been based on some form of dynamic literal count. How circuit information can be used to enhance this basic mechanism, is discussed herein.

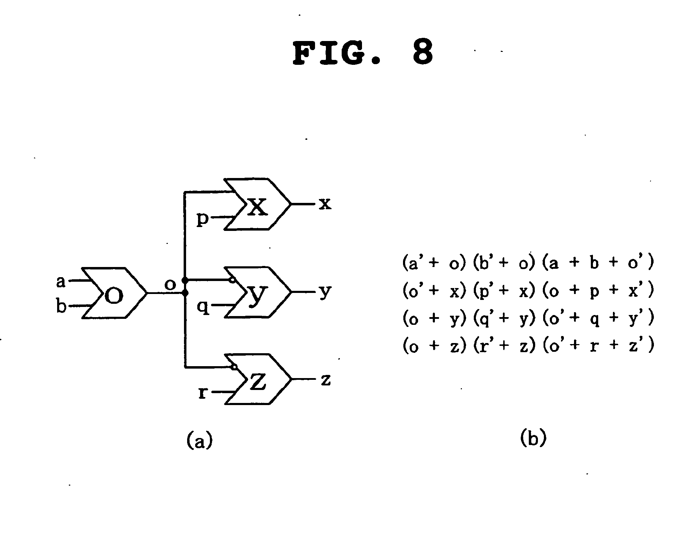

It has been observed that a CNF based solver counts the number of positive and negative literals in clauses so that it may choose a literal that satisfies the largest number of clauses. What is really the issue is to obtain consistent values at the inputs and output of each gate. Counting literals in clauses does not address that as shown in FIG. 8. The OR gate *o* has inputs *a* and *b*, and fanout gates *x*, *y*, and *z*, as shown in FIG. 8(a). The clauses generated are shown in FIG. 8(b). One can see that when a variable is an input, its positive and negative literal counts in the clauses cancel out. When it is an output of a gate, its positive literal count is always one more than the negative literal count. The corresponding scores in FIG. 8(b) are 5 and 4, respectively. In short, the literal count actually does not provide any useful information for clauses generated from gates. With the gate fanout information, on the other hand, one can accurately determine the number of positive and negative fanouts of a gate for decision-making. This is called **fanout** heuristic. The column H2-fs indicates the SAT time with this heuristic. While this heuristic is not a clear winner, it does give better results than the original hybrid approach (H2) in a slight majority (26/45) of examples.

Clauses that do not determine the satisfaction of the formula are termed inactive clauses <27>. These clauses arise from gates that become unobservable. Processing of these clauses and decisions on variables in these clauses is basically wasted effort. Dynamic detection and removal of these clauses requires repeated marking and unmarking of these clauses. Even though these run time operations lead to a pruned search space, the repeated marking and unmarking leads to a loss in the overall performance. Note that this performance improvement is shown only in reachability analysis. In a propagation-justification type of Boolean reasoning mechanism operating on a circuit <24>, dynamic detection of unobservable gates and inactive regions happens automatically. The variables that need to be justified are called *frontier variables.* This strategy is applied by restricting the variable decisions to only those unassigned gates on the dynamically changing frontier. This is called **frontier** heuristic. This heuristic also has the benefit of leading to a satisfying assignment faster when it exists. The column H2-ft indicates the SAT time with this heuristic. Better results than the original hybrid approach (H2) are obtained in 80% of the examples.

The run time with the **frontier** and **fanout** heuristics both in use is shown in column H2-ft-fs. Again, a speed up is observed over H2 in about 73% of the examples.

### c) Learning XOR/XNOR Gates

Circuits with large numbers of XOR and XNOR gates are known to degrade the performance of SAT solvers. Given the uniform-gate circuit representation, it is possible and efficient to extract XOR and XNOR gates in the circuit. In the hybrid representation, clauses for these XOR/XNOR gates are learnt and added to the CNF clause database. The run time with this learning applied in conjunction with the **frontier** and **fanout** heuristics is shown in column H2-ft-fs-slx. With all the three heuristics in place, a speed up is observed over the basic hybrid approach (H2) in more than 62% of the examples.

### d) Best Results with the Hybrid Solver

The best results obtained with the hybrid solver are shown in column H-best. It is clear that the hybrid solver is faster than Chaff in all the examples. The ratio of the Chaff time to the best hybrid solver time is shown in the column Chaff/H-best. *The speed up is greater than 50% in all of the examples* and greater than 2 in 69% of the examples. The heuristics in Table 3 are clearly immature and require further study. It is clear, though, that the H2-ft heuristic works fairly well and could be used as by default.

### e) Implications on Bounded Model Checking

SAT is a core engine in applications like BMC. In fact, it can be expected that in a typical BMC run requiring analysis of the circuit for 50-100 time frames the SAT solver would be called *thousands* of times. With the SAT solver consuming on the order of a few minutes per call, it is typical for a long BMC run to last for multiple days. A speed up by a factor of two in the core engine, therefore, can prove to be very significant since it would lead to a very large absolute run time saving. Another aspect of this works is that it demonstrates clearly that circuit SAT techniques are competitive and superior to CNF based techniques. The practical effect is that it is unnecessary to incur the overhead of copying the entire circuit into a CNF data structure for the purpose of SAT. This has the benefit of almost halving the memory requirement of these applications, allowing them to scale to larger circuits, or in the case of BMC, also to larger number of time frames.

### 6. Experimental Results for Production Designs

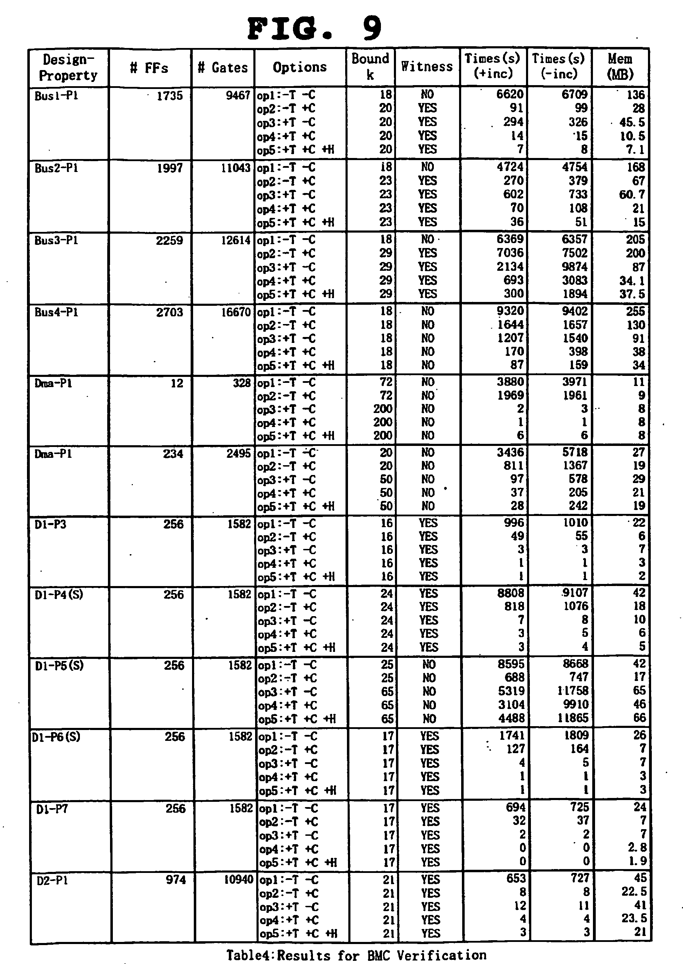

An implementation of BMC engine has been applied in Diver for verification of some production designs. Each verification task consisted of searching for a witness (or a counterexample) for the desired property. The properties included both safety and liveness. The results are summarized in Table 4 (shown in FIG.9). Most experiments were performed on a 750 MHz Intel PIII with 256 MB. Some experiments, indicated by "(S)" in the table, were performed on a Sun UltraSparc 440 MHz, 1GB workstation.

For each design, experiments are conducted for five different sets of options, listed in Column 4. The first four sets relate to the four different combinations of customized translations (denoted +/- T) and circuit simplification using structural isomorphism (denoted +/- C). (Circuit simplification resulting from propagation of constants is always used as a default.) The first set op1 uses neither, the second set op2 uses only circuit simplification, the third set op3 uses only customized translations, while the fourth set op4 uses both. All four sets use a modified version of the Chaff SAT solver <10>, which is capable of using incremental SAT techniques described in Section 6. Finally, the fifth set op5 also uses customized translations and circuit simplification, i.e. the same options as the fourth set, but with a Hybrid SAT solver (denoted +H), as described in Sections 8 and 9.

It is also interesting to examine how much of the potential performance gain might be due to use of incremental SAT techniques. Therefore, experiments were conducted for all five sets of options, with and without use of incremental SAT techniques in the SAT solver. Note that the customized translations always use an incremental formulation, whether or not the SAT solver uses incremental SAT techniques.

In Table 4, the results are shown for all five sets of options (marked 1 through 5) for some designs and properties. The second and third columns report the number of flip-flops and number of gates, respectively, in the static cone of influence for each property (same for all sets). The fifth column reports the number of time frames unrolled to find the witness/counterexample, i.e. the parameter $k$ for BMC, while the sixth column reports whether or not a witness was found for that $k$. The next two columns report the time taken (in seconds) *with* and *without* the use of incremental SAT techniques, denoted +Inc and - Inc, respectively. The last column reports the memory required (in Mbytes) for performing the verification with incremental SAT techniques. (The memory used by the verification without incremental SAT was about the same, for most examples.)

The effectiveness of the disclosed enhancements can be seen clearly from the consistent performance improvements of option sets 2 through 5, in comparison to basic BMC (option set 1). The bigger examples show a performance improvement of up to two orders of magnitude for the same bound $k$. Note that in many cases, basic BMC could not complete as many time frames as BMC with enhancements within the allotted time (10k seconds). In particular, it was not successful in finding a witness for the Bus examples.

Among the enhancements, the use of only customized translations (op3) gave better performance than use of only circuit simplification (op2) for most examples. However, the combination of using both (op4) is always better than using only one or the other. Finally, use of the Hybrid SAT solver (op5) enhances this performance in most examples.

In terms of use of incremental SAT techniques, note that the gains in using incremental SAT techniques are the lowest with basic BMC (op1), where only circuits constraints are shared across different $k$-instances of BMC. The real benefit of incremental SAT is demonstrated by our customized translations, which offer additional opportunities for sharing constraints within each $k$-instance of BMC as well. Therefore, the improvement factors are generally greater with use of customized translations (op3, op4, op5) than without (op1, op2). This can be seen clearly for the bigger examples -Bus3, Dma2, and D1-P5 - where the SAT solving time is found to be non-negligible. Note also that the comparative gain from using incremental SAT techniques in the SAT solver is less than that from using the customized translations. This indicates the benefits of the incremental formulations as a partitioning strategy, even when the constraint sharing is not exploited by the SAT solver.

7. Proofs by Induction for Safety Properties

Apart from finding bounded-length counterexamples, a BMC engine can also be used for performing proofs by induction[16]. Induction with increasing depth $k$, and restriction to loop-free paths, provides a complete proof technique for safety properties [5, 11]. Induction with depth $k$ consists of the following two steps:

- Base case: to prove that the property holds on every $k$-length path starting from the initial state.

- Inductive step: to prove that if the property holds on a $k$-length path starting from any state, then it also holds on all its extensions to a $(k+1)$-length path.

The restriction to loop-free paths imposes the additional constraints that no two states in the paths are identical. Note that the base case includes use of the initial state constraint, but the inductive step does not. Therefore, the inductive step may include unreachable states also. In practice, this may not allow the induction proof to go through without the use of additional constraints, i.e. stronger induction invariants than the property itself. In particular, any circuit constraints known by the designers can be used to strengthen the induction invariants, including reachability constraints.

**a) BMC Procedure for Proof by Induction**

The induction procedure used in the BMC engine is discussed herein. Following is an example pseudo-code.

```
/* p_i, c_i: property node p, constraint node c
at th time frame,
starting from unconstrained state
I: initial state constraint
R: Reachability constraint,
 e.g. over-approximate reachable set */
1 bmc_induction_proof(p,c,R,I)
2 {
3 BC = I;
4 IC = R & c_0;
5 if (!is_sat(IC & !p_0)
6 return true;
7 for (i = 0; i < N; i++) {
8 BC = BC & c_i;
9 // Base case: if sat, counterexample
10 if (is_sat(BC & !p_i))
11 return false;
12 BC = BC & p_i;
13 IC = IC & p_i;
14 IC = IC & c_i+1;
15 // Inductive step: if unsat, found proof
16 if (!is_sat(IC&loop_free(0,i+1)& !p_i+1))
17 return true;
18 }
19 return inconclusive;
20 }
```

Here, $p$ denotes the monitor predicate corresponding to the safety property to be proved true, i.e. the correctness property is $G(p)$. Given an arbitrary safety property expressed in LTL, a monitor predicate can be obtained by using tableaux construction techniques [1], such that the safety property is true if and only if the monitor predicate is true in every reachable state. In the shown pseudo-code, $c$ denotes any circuit constraints known to be true; $I$ denotes the initial state constraint, and $R$ denotes the reachability constraint. Note that the example proof procedure discussed herein assumes both $c$ and $R$ to hold, i.e. $c_i$ must be true in every time frame, and $R$ must be an over-approximation of the reachable states. (If unavailable, each can be regarded as "true" in the pseudo-code.)

In the pseudo-code, $BC$ is the clause database for performing the base case checks, and $IC$ is the clause database for performing the inductive step check. The procedure is started by initializing (lines 3, 4). The first SAT check (line 5) is performed to see if any state which satisfies c and R also satisfies $!p$. If no such state exists, clearly the property $p$ is true - this provides an early termination case without even starting a proof by induction. The loop on $i$ (lines 7-18) performs a proof by induction with increasing depth, up to the user-specified limit $N$. First, the base case is checked by adding the constraint $c\_i$, and checking for the satisfiability of $!p\_i$ in the $i^{th}$ time frame. If it is satisfiable, a counterexample starting from the initial state has been found, and the property is false (lines 10, 11). However, if this is not satisfiable, then $p\_i$ is learned and added to the *BC* database (line 12). Next, the inductive step for the $(i+1)^{th}$ time frame is checked. It is assumed that $p\_i$ is true according to the inductive hypothesis (line 13), constraint $c\_i+1$ is also added (line 14), and the satisfiability of $!p\_i+1$ is checked (line 16) along with the restriction that the *(i+1)-*length path is loop-free. If this is not satisfiable, then the proof by induction has succeeded, and the property is indeed true. However, if it is satisfiable, then the proof has failed at depth $i$, and we try the loop again by incrementing $i$. If the limit $N$ is reached, then the result is inconclusive.

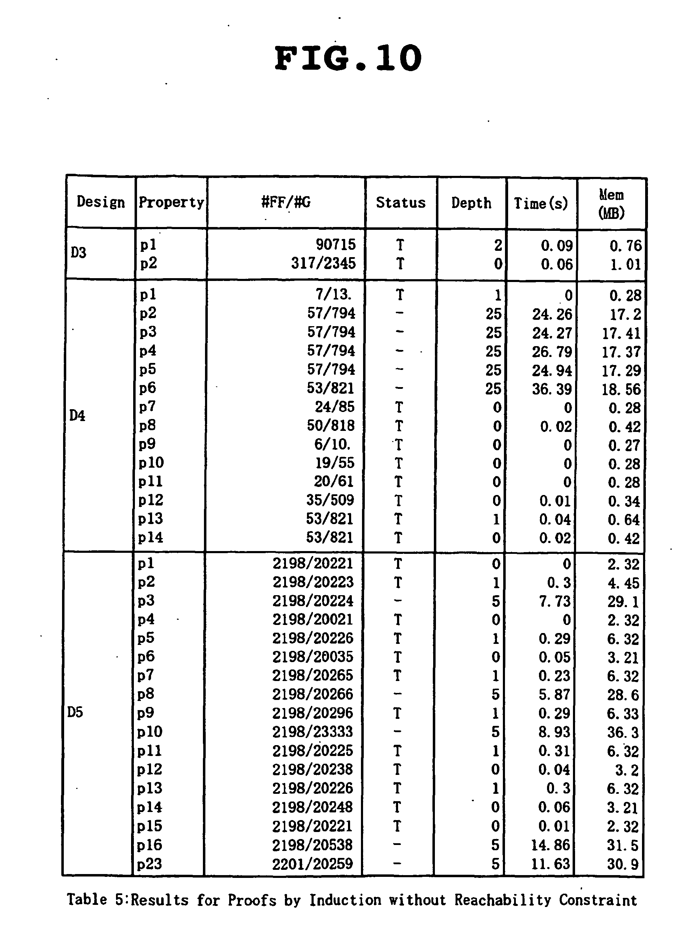

Rather than generate a monolithic SAT formula for each of the base case and inductive steps for depth $i$, the procedure builds the SAT subproblems incrementally, while learning from unsatisfiable SAT instances. Due to these enhancements, the disclosed BMC engine is effective at performing such proofs in practice, as demonstrated by the experimental results on several industrial strength designs. These results are shown in Table 5 (shown in FIG.10), for experiments performed on a Sun UltraSparc 440 MHz, 1 GB workstation.

Proofs by induction were performed for designs (Column 1) and safety properties (Column 2) for which the BMC engine was unable to find a counterexample. For these proofs, circuit constraints provided by the designers were used, but no reachability constraints were used. Column 3 reports the number of flip-flops (#FF) and gates (#G) in the cone of influence of the property. Column 4 reports the verification status, where "T" indicates that the property was proved to be true, while "-" indicates that the induction proof was inconclusive. Note that the BMC engine was able to prove 23 of the 33 properties to be true. In Column 5 we report the depth up to which the proof by induction was carried out. All successful proofs were found in depth less than 2. On the other hand, the inconclusive proofs did not succeed up to depth 25 for many properties. Finally, Columns 6 and 7 report the time (in seconds) and the memory (in Mbytes) required to conduct the proof. Note that these requirements are very modest, even for depth 25.

The next section describes an attempt to find effective reachability invariants and use them for proofs by induction.

### 8. Combining BMC and BDDs

In this section, a novel framework for combining BDDs and SAT-based BMC is presented. Indeed the main idea is quite general - to use any external information about state sets, computed as BDDs, to constrain the search in BMC. As a practical issue, since BDD manipulation tends to be resource intensive (both in time and memory), the BDDs are converted to either circuit or CNF form, which can then be handled as circuit/CNF constraints by the BMC engine.

The use of this framework for proofs by induction is as follows. The first task is to obtain an over-approximation of the set of reachable states. This can be done in various ways. For example, an "existential" abstraction of the design can be performed by abstracting away some latches as pseudo-primary inputs. Good candidates for such abstraction are peripheral latches that do not contribute to the sequential core, or latches that are farther in the dependency closure of the property signals etc. Essentially, the abstract design should contain a superset of the paths in the real design. Therefore, a BDD-based symbolic traversal can be used to obtain an over-approximate set of reachable states. Instead of exact traversal on the abstract design, approximate traversal techniques can also be used <28, 29>. In addition, over-approximation techniques for BDDs can be used to further reduce the size of the final BDD <30>.

Once an over-approximate set of reachable states is obtained as a BDD (or a set of BDDs), the task is to convert it to a form suitable for the BMC engine. At this time, a BDD is converted to a circuit/CNF form, where each internal BDD node is regarded as a multiplexor controlled by the BDD variable (in this case, a "state" variable). This derived circuit/CNF is added as a reachability constraint to the BMC engine, to be used in the induction proof procedure described herein in pseudo-code form.

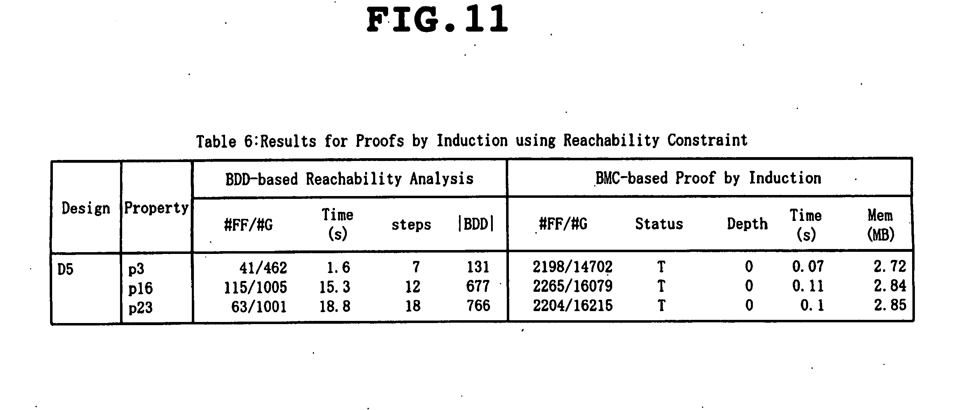

Practical instances have been found where the use of a BDD-based reachability constraint enabled an induction proof to go through, whereas the proof without this constraint did not succeed. The experimental results are shown in Table 6 (shown in FIG.11). Again, the experiments were performed on a Sun UltraSparc 440 MHz, 1 GB workstation. Here, Columns 3 through 6 report the results for BDD-based reachability analysis on the abstract design, while Columns 7 through 11 report the results for the BMC-based proof by induction on the full design. For these experiments, the abstract designs were obtained automatically from the unconstrained designs, by abstracting away latches farther in the dependency closure of the property signals. This took less than a minute in each case. Column 3 reports the number of flip-flops (#FF) and gates (#G) in the abstract design. Note that these numbers are much smaller than the corresponding numbers in the full design (Column 7). Column 4 reports the time taken (in seconds) for the symbolic traversal of the abstract design including its conversion to circuit form. The number of iterations required for symbolic traversal is reported in Column 5, and the final size of the BDD (after further over-approximation in some cases) is reported in Column 6. For the BMC induction proof, Columns 8 and 9 report the verification status and depth of induction, respectively. Note that in each case the proof went through very easily. Finally, Columns 10 and 11 report the time and memory used by the BMC engine.

The important point to note from these results is that despite gross approximations in the BDD-based analysis, in order to keep the BDD time and size requirements quite low, the reachability constraints obtained were strong enough to let the induction proof go through with BMC. Though neither the BDDs, nor the BMC engine, could individually prove these safety properties, their combination with our framework allowed the proof to be completed in less than 20 seconds!

The main motivation for working with the combined framework is that the capabilities of a SAT-based BMC engine are inherently path-based, while BDD-based symbolic analysis is inherently set-based. Therefore, BDDs can be used to complement the capabilities of a pure BMC engine wherever possible. Another line of application for this framework is to find counterexamples/witnesses for arbitrary CTL properties. By performing BDD-based approximate model checking on abstractions of a given design, BDD-based representations of a "witness graph" can be obtained <18>. These sets can then be used to constrain or prioritize the search for counterexamples in the BMC engine.

Other modifications and variations to the invention will be apparent to those skilled in the art from the foregoing disclosure and teachings. Thus, while only certain embodiments of the invention have been specifically described herein, it will be apparent that numerous modifications may be made thereto without departing from the scope of the invention.

**Claims**

1. A computer-implemented method for verification of circuits which is capable of bounded model checking of arbitrary Linear Time Logic temporal properties, comprising:

    translating properties expressed with temporal operators F(p), G(p), U(p, q) and X(p) into property checking schemas for performing Boolean satisfiability checks, wherein F represents an eventuality operator, G represents a globally operator, U represents an until operator and X represents a next-time operator;
    checking an overall property by repeated invocations of the property checking schemas for F(p), G(p), U(p, q) and X(p) operators, wherein
    a subset of the property checking schemas is customized to perform a partitioning of a $k^{th}$ instance of a corresponding bounded model checking problem to break up a corresponding Boolean satisfiability problem into multiple smaller Boolean satisfiability subproblems, wherein
    the partitioning is performed across operators, and for each operator both across time frames and within time frames, wherein
    when a choice exists about which operator to check next, the choice is made according to priority determined by degree of difficulty of search estimated to be increasing in the following order: atomic propositions, X operator, F operator, U operator, G operator, and wherein
    the property checking schema, for F(p) comprises

    a) starting search from a given start state at time frame i, with a given constraint database, wherein i=0 corresponds to an initial state,
    b) checking for satisfiability of p in the $i^{th}$ state of a current path,
    c) if satisfiable, terminating the search with success,
    d) if unsatisfiable, learning that p is always false in the $i^{th}$ state and adding this learnt knowledge to the constraint database,
    e) continuing the search by increasing i until some specified limit, and repeating steps b-d, and
    f) terminating the search inconclusively if the specified limit is reached.

2. The method of claim 1 wherein an incremental formulation of a Boolean satisfiability algorithm is used to learn across related subproblems.

3. The method of claim 1 wherein circuit simplification based on constant propagation is used.

4. The method of claim 1 wherein circuit simplification based on detection of structural isomorphism is used.

5. The method of claim 1 wherein Boolean satisfiability checking problems are solved by using a hybrid SAT solver combining use of circuit-based and CNF-based satisfiability algorithms.

6. The method of claim 1 further comprising checking for completeness between steps d and e.

7. The method of claim 6 wherein the checking for completeness further comprises:

(i) adding constraints to ensure that the transition out of the $i^{th}$ state does not visit a state seen earlier in the path, and checking satisfiability of the constraint database;

(ii) if unsatisfiable, terminating the search with failure;

(iii) otherwise, continuing search; and

(iv) repeating steps (i)-(iii) until all previous states have been examined.

8. The method in claim 1 wherein the property checking schema for G(p) comprises:

g) starting search from a given start state at time frame i with a given constraint database, wherein i=0 corresponds to the initial state,

h) adding a constraint to the database to ensure that p is satisfied in the $i^{th}$ state of the current path, and checking for satisfiability,

i) if unsatisfiable, terminating the search with failure,

j) if satisfiable, checking for each $j^{th}$ state from start state to $i^{th}$ state whether it is a loopback state and terminating the search with success if a loopback state is found;

k) checking for each $j^{th}$ state before the start state whether it is a loopback state and terminating the search with success if a loopback state is found;

l) continuing the search by increasing i until some specified limit and repeating steps a-e;

m) terminating the search inconclusively if specified limit is reached.

9. The method of claim 8 therein step j is performed by:

(ji) checking satisfiability of a transition from the $i^{th}$ state to the $j^{th}$ state,

(jii) if the transition of step di is satisfiable, terminating the search with success,

(jiii) if the transition of step di unsatisfiable, learning that such a transition does not exist and adding this knowledge to the constraint database,

(jiv) continuing the search by repeating (ji)-(jiii) until all states from start state to the $i^{th}$ state have been examined.

10. The method of claim 8 wherein step k is performed by:

(ki) checking for satisfiability of p at each state from the $j^{th}$ state up to the start state,

(kii) if unsatisfiable in step ki, quitting Step k and moving to Step l,

(kiii) if satisfieable in step ki, checking satisfiability of a transition from the $i^{th}$ state to the $j^{th}$ state,

(kiv) if the transition of step kiii is satisfiable, terminating the search with success,

(kv) if the transition of step kiii is unsatisfiable, continuing the search by repeating steps ki-kiv until all states from the initial state (i=0) up to the start state have been examined.

11. The method of claim 8 further comprising checking for completeness between steps k and l.

12. The method of claim 11 wherein the checking for completeness further comprises:

(i) adding constraints to ensure that the transition out of the $i^{th}$ state does not visit a state seen earlier in the path, and checking satisfiability of the constraint database,

(ii) if unsatisfiable in step i, terminating the search with failure,

(iii) if satisfiable in step i, continuing search; and

(iv) repeating steps i-iii until all previous states have been examined.

13. The method in claim 1 wherein the property checking schema for U(p, q) comprises:

n) starting search from a given start state at time frame i with a given constraint database, wherein i=0 corresponds to the initial state;

o) checking for satisfiability of q in the $i^{th}$ state of the current path,

p) if satisfiable, terminating the search with success;

q) if unsatisfiable, learning that q is always false in the $i^{th}$ state and adding this knowledge to the constraint database;

r) adding the constraint to the database to ensure that p is satisfied in the $i^{th}$ state, and checking for satisfiability;

s) if unsatisfiable in step r, terminating the search with failure;

t) if satisfiable in step r, continuing the search;

u) continuing the search by increasing i until some specified limit and repeating steps o-t;and

v) terminating the search inconclusively if specified limit is reached.

14. The method of claim 13 further comprising checking for completeness between steps t and u.

15. The method of claim 14, wherein the checking for completeness further comprises:

(i) adding constraints to ensure that the transition out of the $i^{th}$ state does not visit a state seen earlier in the path, and checking satisfiability of the constraint database;

(ii) if unsatisfiable in step i, terminating the search with failure;

(iii) if satisfiable in step i, continuing search; and

(iv) repeating steps i-iii until all previous states have been examined.

16. The method in claim 1 wherein the property checking schema for X(p) comprises:

w) starting search from a start state at time frame i with a given constraint database, where i=0 corresponds to the initial state;

x) unrolling a transition relation one more time frame, and checking for p to be true at time frame i+1,

y) terminating with success if p is found true at time frame i+1,

z) terminating with failure if p is found false at time frame i+1,

$\alpha$) terminating inconclusively if check for p is inconclusive at time frame i+1.

17. The method of claim 1, wherein a subset of satisfiability checks is combined into a single satisfiability check.

18. The method of claim 8, wherein a subset of satisfiability checks is combined into a single satisfiability check.

19. The method of claim 13, wherein a subset of satisfiability checks is combined into a single satisfiability check.

20. The method of claim 16, wherein a subset of satisfiability checks is combined into a single satisfiability check.

21. The method of claim 1 wherein the property checking schema is extended beyond Linear Time Temporal Logic to include properties with a bounded number of EX operators embedded under alternation, by using satisfiability checks to enumerate solutions for EX which are then discounted.

22. The method of claim 1 wherein binary decision diagram based analysis is used to extend bounded model checking approach to Computation Tree Logic properties.

23. A verification program for verification of circuits which is capable of bounded model checking of arbitrary Linear Time Logic temporal properties comprising:

translating properties expressed with temporal operators F(p), G(p), U(p, q) and X(p) into property checking schemas for performing Boolean satisfiability checks, wherein F represents an eventuality operator, G represents a globally operator, U represents an until operator and X represents a next-time operator;

checking an overall property by repeated invocations of the property checking schemas for F(p), G(p), U(p, q) and X(p) operators, wherein

a subset of the property checking schemas is customized to perform a partitioning of a $k^{th}$ instance of a corresponding bounded model checking problem to break up a corresponding Boolean satisfiability problem into multiple smaller Boolean satisfiability subproblems, wherein

the partitioning is performed across operators, and for each operator both across time frames and within time frames, wherein

when a choice exists about which operator to check next, the choice is made according to priority determined by degree of difficulty of search estimated to be increasing in the following order: atomic propositions, X operator, F operator, U operator, G operator, and wherein

the property checking schema, for F(p) comprises

a) starting search from a given start state at time frame i, with a given constraint database, wherein i=0 corresponds to an initial state,

b) checking for satisfiability of p in the $i^{th}$ state of a current path,

c) if satisfiable, terminating the search with success,

d) if unsatisfiable, learning that p is always false in the $i^{th}$ state and adding this learnt knowledge to the constraint database,

e) continuing the search by increasing i until some specified limit, and repeating steps b-d, and

f) terminating the search inconclusively if the specified limit is reached.

**24.** The verification program of claim 23 wherein the program is adapted to perform circuit simplification based on constant propagation.

**25.** The verification program of claim 23 wherein the program is adapted to perform circuit simplification based on detection of structural isomorphism.

**26.** The verification program of claim 23 wherein the program further includes a hybrid SAT solver for solving Boolean satisfiability checking problems and wherein the hybrid SAT solver combines use of circuit-based and CNF-based satisfiability algorithms.


**Patentansprüche**

**1.** Computer-implementiertes Verfahren zur Verifikation von Schaltungen, das in der Lage ist, Bounded-Model-Checking von willkürlichen zeitlinearen logisch temporalen Eigenschaften durchzuführen, mit:

Übersetzung von Eigenschaften, die durch temporale Operatoren F(p), G(p), U(p, q) und X(p) ausgedrückt werden, in Eigenschaftsprüfschemata zur Durchführung von Bool'schen Erfüllbarkeitsprüfungen, wobei F einen Möglichkeitsoperator bezeichnet, G einen Globaloperator, U einen Bisoperator und X einen Nächstzeitoperator bezeichnet,

Prüfung einer Gesamteigenschaft durch wiederholten Aufruf der Eigenschaftsprüfschemata für die Operatoren F(p), G(p), U(p, q) und X(p), wobei

ein Untersatz der Eigenschaftsprüfschemata angepasst wird, um eine Aufteilung eines k-ten Falls eines entsprechenden Bounded-Model-Checking-Problems durchzuführen, um ein entsprechendes Bool'sches Erfüllbarkeitsproblem in mehrere kleinere Bool'sche Erfüllbarkeits-Subprobleme zu unterteilen, wobei

die Aufteilung über Operatoren und für jeden Operator sowohl über Zeitrahmen und innerhalb von Zeitrahmen durchgeführt wird, wobei,

wenn eine Wahl darüber existiert, welcher Operator zunächst zu prüfen ist, die Wahl entsprechend der Priorität durchgeführt wird, die durch den Schwierigkeitsgrad der Suche bestimmt wird, die ansteigend in der folgenden Reihenfolge abgeschätzt ist: atomare Aussage, X-Operator, F-Operator, U-Operator, G-Operator und wobei das Eigenschaftsprüfschema für F(p) aufweist

a) Beginn der Suche von einem gegebenen Startzustand an einem Zeitrahmen i mit einer gegebenen Bedingungsdatenbank, wobei i = 0 einem Anfangszustand entspricht,

b) Prüfen hinsichtlich der Erfüllbarkeit von p in dem i-ten Zustand eines momentanen Pfades,

c) falls erfüllbar, Abschluss der Suche mit Erfolg,

d) falls nicht erfüllbar, Lernen, dass p immer in dem i-ten Zustand falsch ist und Zufügen dieses erlernten Wissens in die Bedingungsdatenbank,

e) Fortsetzen der Suche durch Erhöhen von i bis zu einer bestimmten Grenze und wiederholen der Schritte b-d, und

f) Beenden der Suche als ergebnislos, falls die vorgegebene Grenze erreicht wird.

**2.** Verfahren nach Anspruch 1, wobei eine inkrementale Formulierung eines Bool'schen Erfüllbarkeitsalgorithmus verwendet wird, um über die zugehörigen Subprobleme hinweg zu lernen.

**3.** Verfahren nach Anspruch 1, wobei eine Schaltungsvereinfachung auf Grund von Konstantenfortpflanzung verwendet wird.

**4.** Verfahren nach Anspruch 1, wobei eine Schaltungsvereinfachung auf Grund von Erfassung von strukturellen Isomorphismen verwendet wird.

**5.** Verfahren nach Anspruch 1, wobei Bool'sche Erfüllbarkeitsprobleme gelöst werden durch Verwendung eines Hybrid-SAT-Beweisers, der die Verwendung von schaltungsbasierten und CNF-basierten Erfüllbarkeitsalgorithmen kombiniert.

**6.** Verfahren nach Anspruch 1 mit ferner der Überprüfung auf Vollständigkeit zwischen den Schritten d und e.

**7.** Verfahren nach Anspruch 6, wobei die Überprüfung hinsichtlich Vollständigkeit ferner aufweist:

(i) Addieren von Bedingungen zur Sicherstellung, dass der Übergang aus dem i-ten Zustand nicht zu einem Zustand führt, der früher in dem Pfad gesehen wurde, und Prüfen der Erfüllbarkeit der Bedingungsdatenbank,
(ii) falls nicht erfüllbar, Beenden der Suche mit Fehler,
(iii) anderenfalls Fortsetzung der Suche und
(iv) Wiederholen der Schritte (i)-(iii) bis alle vorherigen Zustände geprüft wurden.

**8.** Verfahren nach Anspruch 1, wobei das Eigenschaftsprüfschema für G(p) aufweist:

g) Beginnen der Suche von einem gegebenen Startzustand beim Zeitrahmen i mit einer vorgegebenen Bedingungsdatenbank, wobei i=0 dem Anfangszustand entspricht,
h) Addieren einer Bedingung an die Datenbank um sicherzustellen, dass p in dem i-ten Zustand des momentanen Pfades erfüllt ist, und Prüfen hinsichtlich der Erfüllbarkeit,
i) falls nicht erfüllbar, Beenden der Suche mit Fehler,
j) falls erfüllbar, Überprüfung für jeden j-ten Zustand vom Startzustand bis in den i-ten Zustand, ob es ein Rückschleifenzustand ist, und Beenden der Suche mit Erfolg, falls ein Rückschleifenzustand gefunden wird,
k) Überprüfen für jeden j-ten Zustand vor dem Startzustand, ob es ein Rückschleifenzustand ist, und Beenden der Suche mit Erfolg, falls ein Rückschleifenzustand gefunden wurde,
l) Fortsetzen der Suche durch Erhöhen von i bis zu einer vorgegebenen Grenze und Wiederholen der Schritte a-e,
m) Beenden der Suche als erfolglos, falls die vorgegebene Grenze erreicht wird.

**9.** Verfahren nach Anspruch 8, wobei der Schritt j durchgeführt wird durch

(ji) Überprüfen der Erfüllbarkeit eines Überganges vom i-ten Zustand in den j-ten Zustand,
(jii) falls der Übergang des Schrittes di erfüllbar ist, Beendigung der Suche mit Erfolg,
(jiii) falls der Übergang des Schrittes di nicht erfüllbar ist, Lernen, dass ein derartiger Übergang nicht existiert, und Addieren dieser Erkenntnis in die Bedingungsdatenbank,
(jiv) Fortsetzen der Suche durch Wiederholen von (ji)-(jiii) bis alle Zustände vom Startzustand in den i-ten Zustand geprüft wurden.

**10.** Verfahren nach Anspruch 8, wobei der Schritt k durchgeführt wird durch:

(ki) Prüfen von p in jedem Zustand vom j-ten Zustand bis zum Startzustand hinsichtlich der Erfüllbarkeit,
(kii) falls im Schritt ki nicht erfüllbar, Beenden des Schrittes k und Bewegen zum Schritt l,
(kiii) falls im Schritt ki erfüllbar, Überprüfen der Erfüllbarkeit eines Übergangs vom i-ten Zustand in den j-ten Zustand,
(kiv) falls der Übergang des Schrittes kiii erfüllbar ist, Beendigen der Suche mit Erfolg,
(kv) falls der Übergang des Schrittes kiii nicht erfüllbar, Fortsetzung der Suche durch Wiederholen der Schritte ki-kiv bis alle Zustände von dem Anfangszustand (i=0) bis zu dem Startzustand geprüft wurden.

**11.** Verfahren nach Anspruch 8 mit ferner dem Überprüfen hinsichtlich der Vollständigkeit zwischen den Schritten k und l.

**12.** Verfahren nach Anspruch 11, wobei die Prüfung hinsichtlich der Vollständigkeit ferner aufweist:

(i) Addieren von Bedingungen zur Sicherstellung, dass der Übergang aus dem i-ten Zustand nicht zu einem Zustand führt, der früher in dem Pfad gesehen wurde, und Überprüfen hinsichtlich der Erfüllbarkeit der Bedingungsdatenbank,
(ii) falls im Schritt i nicht erfüllbar, Beendigung der Suche mit Fehler,
(iii) falls im Schritt i erfüllbar, Fortsetzung der Suche, und
(iv) Wiederholen der Schritte i-iii bis alle vorherigen Zustände geprüft wurden.

**13.** Verfahren nach Anspruch 1, wobei das Eigenschaftsprüfschema für U(p, q) aufweist:

n) Beginnen der Suche von einem vorgegebenen Startzustand in einem Zeitrahmen i mit einer vorgegebenen Bedingungsdatenbank, wobei i=0 dem Anfangszustand entspricht,

o) Prüfen hinsichtlich der Erfüllbarkeit von q im i-ten Zustand des momentanen Pfades,

p) falls erfüllbar, Beendigung der Suche mit Erfolg,

q) falls nicht erfüllbar, Lernen, dass q immer in dem i-ten Zustand falsch ist, und Addieren dieser Erkenntnis zur der Bedingungsdatenbank,

r) Addieren der Bedingung in der Datenbank um sicherzustellen, dass p in dem i-ten Zustand erfüllt ist, und Prüfen hinsichtlich der Erfüllbarkeit,

s) falls nicht erfüllbar im Schritt r, Beenden der Suche mit Fehler,

t) falls erfüllbar im Schritt r, Fortsetzung der Suche,

u) Fortsetzen der Suche durch Erhöhen von i bis eine vorgegebene Grenze erreicht ist und Wiederholen der Schritte o-t und

v) Beendigung der Suche als ergebnislos, falls die vorgegebene Grenze erreicht wird.

14. Verfahren nach Anspruch 13 mit ferner der Prüfung hinsichtlich Vollständigkeit zwischen den Schritten t und u.

15. Verfahren nach Anspruch 14, wobei das Prüfen hinsichtlich der Vollständigkeit ferner aufweist:

(i) Zufügen von Bedingungen zur Sicherstellung, dass der Übergang aus dem i-ten Zustand nicht zu einem Zustand führt, der vorher in dem Pfad gesehen wurde, und Prüfen der Erfüllbarkeit der Bedingungsdatenbank,

(ii) Falls nicht erfüllbar im Schritt i, Beendigung der Suche mit Fehler,

(iii) Falls erfüllbar im Schritt i, Fortsetzung der Suche und

(iv) Wiederholen der Schritte i-iii bis alle vorhergehenden Zustände geprüft wurden.

16. Verfahren nach Anspruch 1, wobei das Eigenschaftsprüfschema für X(p) aufweist:

w) Beginnen der Suche von einem Anfangszustand zum Zeitrahmen i mit einer vorgegebenen Bedingungsdatenbank, wobei i=0 dem Anfangszustand entspricht,

x) Abwickeln einer Übergangsbeziehung eines weiteren Zeitrahmens und Prüfen, ob p im Zeitrahmen i + 1 wahr ist,

y) Beendigung mit Erfolg, falls p im Zeitrahmen i + 1 als wahr gefunden wurde,

z) Beendigung mit Fehler, falls p im Zeitrahmen i + 1 als falsch gefunden wurde,

α) Beendigung ohne Erfolg, falls die Prüfung für p im Zeitrahmen i + 1 ergebnislos ist.

17. Verfahren nach Anspruch 1, wobei ein Untersatz von Erfüllbarkeitsprüfungen in eine einzelne Erfüllbarkeitsprüfung kombiniert werden.

18. Verfahren nach Anspruch 8, wobei ein Untersatz von Erfüllbarkeitsprüfungen in eine einzelne Erfüllbarkeitsprüfung kombiniert werden.

19. Verfahren nach Anspruch 13, wobei ein Untersatz von Erfüllbarkeitsprüfungen in eine einzelne Erfüllbarkeitsprüfung kombiniert werden.

20. Verfahren nach Anspruch 16, wobei ein Untersatz von Erfüllbarkeitsprüfungen in eine einzelne Erfüllbarkeitsprüfung überführt werden.

21. Verfahren nach Anspruch 1, wobei das Eigenschaftsprüfschema über eine zeitlineare temporale Logik ausgedehnt wird, um Eigenschaften mit einer begrenzten Zahl von EX-Operatoren einzuschließen, die unter Abwechslung eingebettet sind, durch Verwendung von Erfüllbarkeitsprüfungen, um Lösungen für EX aufzuzählen, die dann nicht berücksichtigt werden.

22. Verfahren nach Anspruch 1, wobei eine Analyse basierend auf einem binären Entscheidungsdiagramm verwendet wird, um den Ansatz des Bounded-Model-Checking auf Computation-Tree-Logic-Eigenschaften auszudehnen.

23. Verifikationsprogramm zum Verifizieren von Schaltungen, das in der Lage ist, ein Bounded-Model-Checking von willkürlichen zeitlinearen logischen temporalen Eigenschaften durchzuführen, mit:

Übersetzungen von Eigenschaften, die mit temporalen Operatoren F(p), G(p), U(p, q) und X(p) ausgedrückt werden, in Eigenschaftsprüfschemata zur Durchführung von Bool'schen Erfüllbarkeitsprüfungen, wobei F einen Möglichkeitsoperator repräsentiert, G einen Globaloperator repräsentiert, U einen Bisoperator und X einen Nächstzeitoperator repräsentiert,

Prüfen einer Gesamteigenschaft durch wiederholten Aufruf der Eigenschaftsschemata für F(p)-, G(p)-, U(p, q)- und X(p)- Operatoren, wobei ein Untersatz von Eigenschaftsprüfschemata angepasst wird zur Durchführung einer Aufteilung eines k-ten Falls in ein entsprechendes Bounded-Model-Checking-Problem, um ein entsprechendes Bool'sches Erfüllbarkeitsproblem in eine Anzahl von kleineren Bool'schen Erfüllbarkeits-Subproblemen zu unterteilen, wobei die Aufteilung über Operatoren hinweg durchgeführt wird und für jeden Operator sowohl über Zeitrahmen hinweg als auch innerhalb von Zeitrahmen, wobei,

wenn eine Wahl existiert über den Operator, der als nächster zu Prüfen ist, die Wahl entsprechend der Priorität durchgeführt wird, die durch den Schwierigkeitsgrad der Suche bestimmt ist, die abgeschätzt wird, in der folgenden Ordnung anzusteigen, atomare Aussagen, X-Operator, F-Operator, U-Operator, G-Operator, und wobei das Eigenschaftsprüfschema für F(p) aufweist

> a) Beginnen der Suche von einem gegebenen Startzustand im Zeitrahmen i mit einer vorgegebenen Bedingungsdatenbank, wobei i=0 dem Anfangszustand entspricht,
> b) Überprüfen hinsichtlich der Erfüllbarkeit von p im i-ten Zustand eines momentanen Pfades,
> c) falls erfüllbar, Beendigung der Suche mit Erfolg,
> d) falls nicht erfüllbar, Lernen, dass p im i-ten Zustand immer falsch ist und Addieren dieses gelernten Wissens in der Bedingungsdatenbank,
> e) Fortsetzung der Suche durch Ansteigen von i bis zu einer vorgegebenen Grenze und Wiederholen der Schritte b-d, und
> f) Beendigung der Suche ergebnislos, falls die vorgegebene Grenze erreicht wird.

24. Verifikationsprogramm nach Anspruch 23, wobei das Programm ausgebildet ist, eine Schaltungsvereinfachung basierend auf Konstantenfortpflanzung durchzuführen.

25. Verifikationsprogramm nach Anspruch 23, wobei das Programm ausgebildet ist, eine Schaltungsvereinfachung basierend auf der Erfassung von strukturellen Isomorphismen durchzuführen.

26. Verifikationsprogramm nach Anspruch 23, wobei das Programm ferner einen Hybrid-SAT-Beweiser zum Lösen von Bool'schen Erfüllbarkeits-Prüfproblemen aufweist und wobei der Hybrid-SAT-Beweiser die Verwendung von schaltungsbasierten und CNF-basierten Erfüllbarkeitsalgorithmen kombiniert.

**Revendications**

1. Procédé informatique de vérification de circuits, capable d'effectuer une vérification de modèle limitée de propriétés temporelles arbitraires de logique temporelle linéaire et qui consiste :

à traduire des propriétés exprimées à l'aide d'opérateurs temporels F(p), G(p), U(p, q) et X(p) sous forme de schémas de vérification de propriété pour effectuer des vérifications de satisfaisabilité booléenne, F représentant un opérateur d'éventualité, G un opérateur global, U un opérateur jusqu'à et X un opérateur suivant ,
à vérifier une propriété globale par des invocations répétées des schémas de vérification de propriété pour les opérateurs F(p), G(p), U(p, q) et X(p), dans lequel
un sous-ensemble des schémas de vérification de propriété est adapté pour effectuer un partitionnement d'une k$^{\text{ième}}$ instance d'un problème correspondant de vérification de modèle limitée afin de diviser un problème correspondant de satisfaisabilité booléenne en plusieurs petits sous-problèmes de satisfaisabilité booléenne, dans lequel
le partitionnement est effectué entre les opérateurs et pour chaque opérateur, entre les tranches de temps et à l'intérieur des tranches de temps, dans lequel
lorsqu'il existe un choix concernant l'opérateur suivant à vérifier, le choix est fait selon une priorité déterminée par le degré de difficulté de la recherche estimé augmenter dans l'ordre suivant : propositions atomiques, opérateur X, opérateur F, opérateur U, opérateur G, et dans lequel
le schéma de vérification de propriété pour F(p) consiste

> a) à commencer la recherche à partir d'un état de départ donné dans une tranche de temps i, avec une base de données des contraintes donnée, où i = 0 correspond à un état initial,

b) à vérifier la satisfaisabilité de p au $i^{ème}$ état d'un chemin en cours,

c) si p est satisfaisable, à terminer la recherche avec succès,

d) si p est insatisfaisable, à apprendre que p est toujours faux au $i^{ème}$ état et à ajouter cette connaissance apprise à la base de données des contraintes,

e) à continuer la recherche en augmentant i jusqu'à une limite indiquée, et à répéter les étapes b à d, et

f) à terminer la recherche de manière non concluante si la limite indiquée est atteinte.

2. Procédé selon la revendication 1, dans lequel une formulation incrémentielle d'un algorithme de satisfaisabilité booléenne est utilisée pour permettre l'apprentissage entre des sous-problèmes connexes.

3. Procédé selon la revendication 1, dans lequel une simplification des circuits fondée sur la propagation constante est utilisée.

4. Procédé selon la revendication 1, dans lequel une simplification des circuits fondée sur la détection d'un isomorphisme structurel est utilisée.

5. Procédé selon la revendication 1, dans lequel des problèmes de vérification de satisfaisabilité booléenne sont résolus au moyen d'un solveur SAT hybride associant l'utilisation d'algorithmes de satisfaisabilité fondés sur les circuits et fondés sur la forme normale conjonctive (CNF).

6. Procédé selon la revendication 1, consistant en outre à vérifier la complétude entre les étapes d et e.

7. Procédé selon la revendication 6, dans lequel la vérification de la complétude consiste en outre :

(i) à ajouter des contraintes pour s'assurer que la transition de sortie du $i^{ème}$ état ne passe pas par un état vu précédemment sur le chemin, et à vérifier la satisfaisabilité de la base de données des contraintes ,

(ii) si cette dernière est insatisfaisable, à terminer la recherche par un échec ,

(iii) sinon, à continuer la recherche , et

(iv) à répéter les étapes (i) à (iii) jusqu'à ce que tous les états précédents aient été examinés.

8. Procédé selon la revendication 1, dans lequel le schéma de vérification de propriété pour G(p) consiste :

g) à commencer la recherche à partir d'un état de départ donné dans une tranche de temps i avec une base de données des contraintes donnée, où i = 0 correspond à l'état initial,

h) à ajouter une contrainte à la base de donnée pour s'assurer que p est satisfait au $i^{ème}$ état du chemin en cours, et à vérifier sa satisfaisabilité,

i) s'il est insatisfaisable, à terminer la recherche par un échec,

j) s'il est satisfaisable, à vérifier pour chaque $j^{ème}$ état de l'état de départ au $i^{ème}$ état s'il s'agit d'un état de bouclage et à terminer la recherche avec succès si un état de bouclage est trouvé ,

k) à vérifier pour chaque $j^{ème}$ état avant l'état de départ s'il s'agit d'un état de bouclage et à terminer la recherche avec succès si un état de bouclage est trouvé ,

l) à continuer la recherche en augmentant i jusqu'à une limite indiquée et à répéter les étapes a à e ,

m) à terminer la recherche de manière non concluante si la limite indiquée est atteinte.

9. Procédé selon la revendication 8, dans lequel l'exécution de l'étape j consiste :

(ji) à vérifier la satisfaisabilité d'une transition du $i^{ème}$ état au $j^{ème}$ état,

(jii) si la transition de l'étape ji est satisfaisable, à terminer la recherche avec succès,

(jiii) si la transition de l'étape ji est insatisfaisable, à apprendre qu'une telle transition n'existe pas et à ajouter cette connaissance à la base de données des contraintes,

(jiv) à continuer la recherche en répétant les étapes (ji) à (jiii) jusqu'à ce que tous les états de l'état de départ au $i^{ème}$ état aient été examinés.

10. Procédé selon la revendication 8, dans lequel l'exécution de l'étape k consiste :

(ki) à vérifier la satisfaisabilité de p à chaque état depuis le $j^{ème}$ état jusqu'à l'état de départ,

(kii) si p est insatisfaisable à l'étape ki, à quitter l'étape k et à passer à l'étape 1,

(kiii) si p est satisfaisable à l'étape ki, à vérifier la satisfaisabilité d'une transition du $i^{ème}$ état au $j^{ème}$ état,

(kiv) si la transition de l'étape kiii est satisfaisable, à terminer la recherche avec succès,

(kv) si la transition de l'étape kiii est insatisfaisable, à continuer la recherche en répétant les étapes ki à kiv jusqu'à ce que tous les états depuis l'état initial (i = 0) jusqu'à l'état de départ aient été examinés.

**11.** Procédé selon la revendication 8, consistant en outre à vérifier la complétude entre les étapes k et l.

**12.** Procédé selon la revendication 11, dans lequel la vérification de la complétude consiste en outre :

(i) à ajouter des contraintes pour s'assurer que la transition de sortie du $i^{ème}$ état ne passe pas par un état vu précédemment sur le chemin, et à vérifier la satisfaisabilité de la base de données des contraintes ;

(ii) si cette dernière est insatisfaisable à l'étape i, à terminer la recherche par un échec,

(iii) si elle est satisfaisable à l'étape i, à continuer la recherche, et

(iv) à répéter les étapes i à iii jusqu'à ce que tous les états précédents aient été examinés.

**13.** Procédé selon la revendication 1, dans lequel le schéma de vérification de propriété pour U(p, q) consiste :

n) à commencer la recherche à partir d'un état de départ donné dans une tranche de temps i avec une base de données des contraintes donnée, où i = 0 correspond à l'état initial,

o) à vérifier la satisfaisabilité de q au $i^{ème}$ état du chemin en cours,

p) si q est satisfaisable, à terminer la recherche avec succès,

q) si q est insatisfaisable, à apprendre que q est toujours faux au $i^{ème}$ état et à ajouter cette connaissance à la base de données des contraintes,

r) à ajouter la contrainte à la base de données pour s'assurer que p est satisfait au $i^{ème}$ état, et à vérifier sa satisfaisabilité,

s) si p est insatisfaisable à l'étape r, à terminer la recherche par un échec,

t) si p est satisfaisable à l'étape r, à continuer la recherche ,

u) à continuer la recherche en augmentant i jusqu'à une limite indiquée et à répéter les étapes o à t, et

v) à terminer la recherche de manière non concluante si la limite indiquée est atteinte.

**14.** Procédé selon la revendication 13, consistant en outre à vérifier la complétude entre les étapes t et u.

**15.** Procédé selon la revendication 14, dans lequel la vérification de la complétude consiste en outre :

(i) à ajouter des contraintes pour s'assurer que la transition de sortie du $i^{ème}$ état ne passe pas par un état vu précédemment sur le chemin, et à vérifier la satisfaisabilité de la base de données des contraintes,

(ii) si la base de données des contraintes est insatisfaisable à l'étape i, à terminer la recherche par un échec,

(iii) si la base de données des contraintes est satisfaisable à l'étape i, à continuer la recherche, et

(iv) à répéter les étapes i à iii jusqu'à ce que tous les états précédents aient été examinés.

**16.** Procédé selon la revendication 1, dans lequel le schéma de vérification de propriété pour X(p) consiste :

w) à commencer la recherche à partir d'un état de départ dans une tranche de temps i avec une base de données des contraintes donnée, où i=0 correspond à l'état initial,

x) à dérouler une relation de transition sur une tranche de temps supplémentaire, et à vérifier que p est vrai dans la tranche de temps i + 1,

y) à terminer avec succès si p se révèle vrai dans la tranche de temps i + 1,

z) à terminer par un échec si p se révèle faux dans la tranche de temps i + 1,

$\alpha$) à terminer de manière non concluante si la vérification de p n'est pas concluante dans la tranche de temps i + 1.

**17.** Procédé selon la revendication 1, dans lequel un sous-ensemble de vérifications de satisfaisabilité est combiné pour former une seule vérification de satisfaisabilité.

**18.** Procédé selon la revendication 8, dans lequel un sous-ensemble de vérifications de satisfaisabilité est combiné pour former une seule vérification de satisfaisabilité.

**19.** Procédé selon la revendication 13, dans lequel un sous-ensemble de vérifications de satisfaisabilité est combiné pour former une seule vérification de satisfaisabilité.

**20.** Procédé selon la revendication 16, dans lequel un sous-ensemble de vérifications de satisfaisabilité est combiné pour former une seule vérification de satisfaisabilité.

**21.** Procédé selon la revendication 1, dans lequel le schéma de vérification de propriété est étendu au-delà de la logique temporelle linéaire pour inclure des propriétés ayant un nombre limité d'opérateurs EX intégrés en alternance, au moyen de vérifications de satisfaisabilité destinées à énumérer des solutions pour EX qui sont ensuite actualisées.

**22.** Procédé selon la revendication 1, dans lequel une analyse fondée sur un diagramme de décision binaire est utilisée pour étendre l'approche de la vérification de modèle limitée aux propriétés de la logique des arbres de calcul.

**23.** Programme de vérification pour la vérification de circuits, capable d'effectuer une vérification de modèle limitée de propriétés temporelles arbitraires de logique temporelle linéaire et qui consiste :

à traduire des propriétés exprimées à l'aide d'opérateurs temporels F(p), G(p), U(p, q) et X(p) sous forme de schémas de vérification de propriété pour effectuer des vérifications de satisfaisabilité booléenne, F représentant un opérateur d'éventualité, G un opérateur global, U un opérateur jusqu'à et X un opérateur suivant,
à vérifier une propriété globale par des invocations répétées des schémas de vérification de propriété pour les opérateurs F(p), G(p), U(p, q) et X(p), dans lequel
un sous-ensemble des schémas de vérification de propriété est adapté pour effectuer un partitionnement d'une $k^{ième}$ instance d'un problème correspondant de vérification de modèle limitée afin de diviser un problème correspondant de satisfaisabilité booléenne en plusieurs petits sous-problèmes de satisfaisabilité booléenne, dans lequel
le partitionnement est effectué entre les opérateurs et pour chaque opérateur, entre les tranches de temps et à l'intérieur des tranches de temps, dans lequel
lorsqu'il existe un choix concernant l'opérateur suivant à vérifier, le choix est fait selon une priorité déterminée par le degré de difficulté de la recherche estimé augmenter dans l'ordre suivant : propositions atomiques, opérateur X, opérateur F, opérateur U, opérateur G, et dans lequel
le schéma de vérification de propriété pour F(p) consiste

a) à commencer la recherche à partir d'un état de départ donné dans une tranche de temps i, avec une base de données des contraintes donnée, où i = 0 correspond à un état initial,
b) à vérifier la satisfaisabilité de p au $i^{ème}$ état d'un chemin en cours,
c) si p est satisfaisable, à terminer la recherche avec succès,
d) si p est insatisfaisable, à apprendre que p est toujours faux au $i^{ème}$ état et à ajouter cette connaissance apprise à la base de données des contraintes,
e) à continuer la recherche en augmentant i jusqu'à une limite indiquée, et à répéter les étapes b à d, et
f) à terminer la recherche de manière non concluante si la limite indiquée est atteinte.

**24.** Programme de vérification selon la revendication 23, dans lequel le programme est apte à effectuer une simplification des circuits fondée sur la propagation constante.

**25.** Programme de vérification selon la revendication 23, dans lequel le programme est apte à effectuer une simplification des circuits fondée sur la détection d'un isomorphisme structurel.

**26.** Programme de vérification selon la revendication 23, dans lequel le programme comprend en outre un solveur SAT hybride destiné à résoudre des problèmes de vérification de satisfaisabilité booléenne et dans lequel le solveur SAT hybride associe l'utilisation d'algorithmes de satisfaisabilité fondés sur les circuits et fondés sur la forme normale conjonctive (CNF).

# FIG. 1

Designes Verified
- bus core
- memory arbiter
- DMA Controller
- prototyping platform
- USB Core
- memory interface

design.v

AG(req ->AF(ack + error)
"request always followed
by an ack or error"

Design

Property

Environment
Model

DiVer

Verification
Platform
For
Digital
Systems

Constraints

Technology : Formal Verification

System features

- highly automated
- superior algorithms
- handles large designs
- smart debugger
- more effective than simulation

Efficient Implicit State Exploration
3 Main Engines :
- BDDs: property proofs
- BDD+SAT: superior to BDDs
- SAT: bug detection

Verification
Report

| signals | waves |
|---|---|
| Time | |
| clock[15:0]=0006 | 0000 0001 0002 0003 0004 0005 0006 0007 0008 0009 000A 000B 000C |
| state[15:0]=0006 | 0000 0001 0002 0003 0004 0005 0006 0007 0008 0009 000A 000B |
| bus_Error=0 | |
| + Acknowledge=0 | |
| + Request=0 | |

Bug found in bus design (1735 flip-flops) in just 10s.
Cannot be found by other means!

EP 1 515 251 B1

# FIG. 2

$S_1$                    $S_k$

(a) no loop

$S_1$

(b) (k-1) loop

# FIG. 3

Circuit-based BCP Procedure

```
Algorithm imply(vartex, value) {
  assign(vertex, value);
  lvalue = get_value(vertex->left);
  rvalue = get_value(vertex->right);
  next_state = lookup(value, lvalue, rvalue);
  switch(next_state) {
   case CONFLICT :
    return 0;
   case CASE_SPLIT :
    add_vertex(vertex, justification_queue);
    return 1;

    ...


   case PROP_LEFT_AND_RIGHT :
    if (imply(vertex->left, next_state->lvalue) &&
      imply(vertex->right, next_state->rvalue)) {
      return 1;
    }
    return 0;

    ...

  }
  return 1;
}
```

# FIG. 4

2-Input AND Lookup Table for Fast Implication Propagation

| Current | Next | Action |
|---------|------|--------|
| | | STOP |
| | | CONFLICT |
| | | CASE_SPLIT |
| | | PROP_FORWARD |
| | | PROP_LEFT_RIGHT |
| . . . | . . . | . . . |

# FIG. 5

| Logic Formula | pi | gate | BCP Time (sec/million implications) | | | | | |
|---|---|---|---|---|---|---|---|---|
| | | | Hybrid | Chaff | CH | Structure | CS | HS |
| 230U | 5016 | 228346 | 1.154 | 1.589 | 1.37 | 0.9 | 1.76 | 1.28 |
| 252U | 5244 | 242170 | 1.168 | 1.586 | 1.35 | 0.914 | 1.73 | 1.28 |
| 272U | 5244 | 238755 | 1.101 | 1.411 | 1.28 | 0.894 | 1.578 | 1.23 |
| 274U | 3863 | 179217 | 1.11 | 1.52 | 1.369 | 0.908 | 1.67 | 1.22 |
| 275U | 5472 | 255979 | 1.162 | 1.566 | 1.347 | 0.955 | 1.64 | 1.22 |
| 276U | 5472 | 256000 | 1.172 | 1.571 | 1.34 | 0.91 | 1.72 | 1.29 |
| 405U | 6612 | 325069 | 1.236 | 1.605 | 1.29 | 0.92 | 1.74 | 1.34 |
| 406U | 6612 | 325090 | 1.207 | 1.639 | 1.35 | 0.94 | 1.74 | 1.28 |
| 407U | 6612 | 325090 | 1.232 | 1.694 | 1.375 | 0.942 | 1.798 | 1.31 |
| 409U | 6612 | 325090 | 1.245 | 1.639 | 1.316 | 0.923 | 1.775 | 1.35 |
| 435U | 6840 | 338899 | 1.233 | 1.668 | 1.35 | 0.995 | 1.676 | 1.24 |
| 2dlx_100 | 557 | 33848 | 1.82 | 2.22 | 1.21 | 0.931 | 2.38 | 1.95 |

Table 1: BCP Time per million implications

EP 1 515 251 B1

# FIG. 6

Table 2: Comparison of Total Run Time Between the Hybrid Solver and Chaff

| Example | pi | gate | Chaff | H | H-jft | Chaff/H | Chaff/H-jft |
|---|---|---|---|---|---|---|---|
| Unsatisfiable Instances | | | | | | | |
| 53U | 6384 | 546779 | 1893.43 | 1629.05 | 639.20 | 1.16 | 2.96 |
| 55U | 6612 | 571185 | 1585.08 | 1402.80 | 715.20 | 1.13 | 2.22 |
| 51U | 6156 | 524116 | 1283.82 | 1010.90 | 508.80 | 1.27 | 2.52 |
| 47U | 5700 | 477047 | 1190.05 | 863.60 | 391.87 | 1.38 | 3.04 |
| 49U | 5928 | 499710 | 1072.64 | 738.30 | 606.70 | 1.45 | 1.77 |
| 435U | 6840 | 338899 | 922.61 | 326.50 | 317.00 | 2.83 | 2.91 |
| 3pipe | 198 | 10810 | 920.50 | 245.60 | 566.90 | 3.75 | 1.62 |
| 45U | 5472 | 452641 | 888.86 | 415.27 | 443.40 | 2.14 | 2.00 |
| 434U | 6840 | 338899 | 880.84 | 532.10 | 318.00 | 1.66 | 2.77 |
| 407U | 6612 | 325090 | 736.49 | 367.20 | 588.00 | 2.01 | 1.25 |
| 438U | 6840 | 338899 | 647.71 | 427.20 | 283.00 | 1.52 | 2.29 |
| 437U | 6840 | 338899 | 621.17 | 281.10 | 419.00 | 2.21 | 1.48 |
| 439U | 6840 | 338899 | 599.14 | 441.80 | 453.00 | 1.36 | 1.32 |
| 436U | 6840 | 338899 | 559.08 | 369.60 | 384.00 | 1.51 | 1.46 |
| 105U | 1017 | 94528 | 547.68 | 248.90 | 506.30 | 2.20 | 1.08 |
| 409U | 6612 | 325090 | 496.31 | 437.20 | 329.00 | 1.14 | 1.51 |
| 406U | 6612 | 325090 | 486.86 | 353.90 | 317.00 | 1.38 | 1.54 |
| 405U | 6612 | 325069 | 471.50 | 585.00 | 445.00 | 0.81 | 1.06 |
| 43U | 5244 | 429978 | 471.13 | 353.87 | 181.25 | 1.33 | 2.60 |
| 109U | 1055 | 101180 | 441.33 | 173.70 | 229.00 | 2.54 | 1.93 |
| 408U | 6612 | 325090 | 433.21 | 358.10 | 347.00 | 1.21 | 1.25 |
| 41U | 5016 | 405572 | 364.03 | 230.27 | 233.80 | 1.58 | 1.56 |
| 39U | 4788 | 382909 | 307.59 | 208.87 | 120.20 | 1.47 | 2.56 |
| 101U | 979 | 88088 | 230.97 | 141.00 | 117.00 | 1.64 | 1.97 |
| 276U | 5472 | 256000 | 193.24 | 132.30 | 104.00 | 1.46 | 1.86 |
| 37U | 4560 | 358503 | 174.47 | 146.96 | 139.12 | 1.19 | 1.25 |
| 252U | 5244 | 242170 | 165.46 | 118.30 | 93.50 | 1.40 | 1.77 |
| 35U | 4332 | 335840 | 165.20 | 128.90 | 76.02 | 1.28 | 2.17 |
| 275U | 5472 | 255979 | 162.97 | 132.10 | 129.00 | 1.23 | 1.26 |
| 230U | 5016 | 228346 | 132.54 | 100.60 | 77.00 | 1.32 | 1.72 |
| 33U | 4104 | 311434 | 98.64 | 80.10 | 42.10 | 1.23 | 2.34 |
| 31U | 3876 | 288771 | 92.22 | 51.30 | 29.30 | 1.80 | 3.15 |
| 2dlx_cc_mc_ex_bp_f_new | 414 | 25075 | 89.07 | 49.30 | 72.40 | 1.81 | 1.23 |
| 272U | 5244 | 238755 | 47.54 | 27.70 | 8.00 | 1.72 | 5.94 |
| Satisfiable Instances | | | | | | | |
| 109S | 2374 | 144590 | 811.12 | 330.4 | 182.5 | 2.45 | 4.44 |
| 105S | 2286 | 134654 | 432.22 | 196.4 | 72.9 | 2.20 | 5.93 |
| 108S | 2367 | 142198 | 423.63 | 766.8 | 138.5 | 0.55 | 3.06 |
| 101S | 2198 | 125070 | 388.35 | 399.38 | 111.9 | 0.97 | 3.47 |
| 102S | 2235 | 127558 | 344.34 | 312.7 | 144.4 | 1.10 | 2.38 |
| 103S | 2242 | 129818 | 343.95 | 481.8 | 86.7 | 0.71 | 3.97 |
| 107S | 2330 | 139578 | 286.1 | 256.4 | 178.2 | 1.12 | 1.61 |
| 104S | 2279 | 132350 | 270.01 | 384.4 | 49.1 | 0.70 | 5.50 |
| 106S | 2323 | 137230 | 226.57 | 198.58 | 94.4 | 1.14 | 2.40 |
| 100S | 2191 | 120305 | 153.41 | 374.8 | 97.8 | 0.41 | 1.57 |
| 2dlx_100 | 557 | 33848 | 120.12 | 76.8 | 17 | 1.56 | 7.07 |

45

# FIG. 7

| Examp | pi | gate | | H1 | H2 | H2- | H2- | H2-ft- | H2-ft-fs- | H- | Chaff/H- |
|---|---|---|---|---|---|---|---|---|---|---|---|
| | | | | | | Unsatisfiable | | | | | |
| 53U | 638 | 54677 | 1893.4 | 1629.0 | 1257. | 639. | 1504. | 522. | 81 | 522. | 3.6 |
| 55U | 661 | 57118 | 1585.0 | 1402. | 1558. | 715. | 1427. | 1279. | 1457. | 715. | 2.2 |
| 51U | 615 | 52411 | 1283.8 | 1010. | 945. | 508. | 1145 | 553.0 | 1583. | 508. | 2.5 |
| 47U | 570 | 47704 | 1190.0 | 863. | 490. | 391.8 | 621. | 370. | 907.2 | 370. | 3.2 |
| 49U | 592 | 49971 | 1072.6 | 738. | 685. | 606. | 847. | 545. | 1093. | 645. | 1.9 |
| 435U | 684 | 33889 | 922.6 | 326. | 37 | 31 | 54 | 49 | 36 | 31 | 2.9 |
| 3pipe | 19 | 1081 | 920. | 245. | 369. | 566. | 81. | 25 | 252. | 81. | 11.3 |
| 45U | 547 | 45264 | 888.8 | 415.2 | 490. | 443. | 387. | 193. | 311. | 193. | 4.5 |
| 434U | 684 | 33889 | 880.8 | 532. | 42 | 31 | 47 | 39 | 35 | 31 | 2.7 |
| 407 | 661 | 32509 | 736.4 | 367. | 34 | 58 | 30 | 31 | 33 | 30 | 2.4 |
| 438U | 684 | 33889 | 647.7 | 427. | 35 | 28 | 37 | 54 | 37 | 28 | 2.2 |
| 437U | 684 | 33889 | 621.1 | 281. | 39 | 41 | 32 | 50. | 30 | 281. | 2.2 |
| 439U | 684 | 33889 | 599.1 | 441. | 36 | 45 | 29 | 35 | 37 | 29 | 2.0 |
| 436U | 684 | 33889 | 559.0 | 369. | 43 | 38 | 45 | 40 | 50 | 369. | 1.5 |
| 105U | 101 | 9452 | 547.6 | 248. | 188. | 506. | 758. | 505. | 54 | 188. | 2.9 |
| 409 | 661 | 32509 | 496.3 | 437. | 381. | 32 | 28 | 43 | 50 | 28 | 1.7 |
| 406 | 661 | 32509 | 486.8 | 353. | 33 | 31 | 36 | 33 | 26 | 26 | 1.8 |
| 405 | 661 | 32506 | 471. | 58 | 31 | 44. | 39 | 35 | 47 | 31 | 1.4 |
| 43U | 524 | 42997 | 471.1 | 353.8 | 374. | 181.2 | 374. | 299. | 279.6 | 181.2 | 2.6 |
| 109U | 105 | 10118 | 441.3 | 173. | 138 | 22 | 107 | 437 | 667. | 173. | 2.5 |
| 408 | 661 | 32509 | 433.2 | 358. | 30 | 34 | 22 | 31 | 29 | 22 | 1.9 |
| 41U | 501 | 40557 | 364.0 | 230.2 | 218. | 233. | 264.8 | 153. | 302.3 | 153. | 2.3 |
| 39U | 478 | 38290 | 307.5 | 208.8 | 194. | 120. | 194.0 | 187.3 | 445. | 120. | 2.5 |
| 101U | 97 | 8808 | 230.9 | 14 | 328. | 11 | 198. | 39 | 360. | 11 | 1.9 |
| 276 | 547 | 25600 | 193.2 | 132. | 11 | 10 | 14 | 11 | 11 | 10 | 1.8 |
| 37U | 456 | 35850 | 174.4 | 146.9 | 152. | 139.1 | 183. | 95. | 192. | 95. | 1.8 |
| 252 | 524 | 24217 | 165.4 | 118. | 11 | 93. | 95 | 71 | 77 | 71 | 2.3 |
| 35U | 433 | 33584 | 165. | 128. | 152.0 | 76.0 | 119.0 | 140. | 307. | 76.0 | 2.1 |
| 275 | 547 | 25597 | 162.9 | 132. | 10 | 12 | 93 | 12 | 10 | 93 | 1.7 |
| 230 | 501 | 22834 | 132.5 | 100. | 97 | 77 | 67 | 83 | 76 | 67 | 1.9 |
| 33U | 410 | 31143 | 98.6 | 80. | 81. | 42. | 83. | 61.6 | 65. | 42. | 2.3 |
| 31U | 387 | 28877 | 92.2 | 51. | 61. | 29. | 50. | 24.0 | 58. | 24.0 | 3.8 |
| 2dlx cc mc ex bp f | 41 | 2507 | 89.0 | 49. | 79. | 72. | 88. | 218. | 39 | 49. | 1.8 |
| 272 | 524 | 23875 | 47.5 | 27. | 24 | 8 | 20 | 15 | 16 | 8 | 5.9 |
| | | | | | | Satisfiable | | | | | |
| 109S | 237 | 14459 | 811.1 | 330. | 402. | 182. | 394. | 13 | 199. | 13 | 6.1 |
| 105S | 228 | 13465 | 432.2 | 196. | 350. | 72. | 331. | 157. | 130. | 72. | 5.9 |
| 108S | 236 | 14219 | 423.6 | 766. | 208. | 138. | 364. | 183. | 238. | 138. | 3.0 |
| 101S | 219 | 12507 | 388.3 | 399.3 | 206. | 111. | 176. | 105. | 139. | 105. | 3.6 |
| 102S | 223 | 12755 | 344.3 | 312. | 238. | 144. | 156. | 123. | 159. | 123. | 2.7 |
| 103S | 224 | 12981 | 343.9 | 481. | 248. | 86. | 151. | 93. | 132. | 86. | 3.9 |
| 107S | 233 | 13957 | 286. | 256. | 42 | 178. | 162. | 156. | 187. | 156. | 1.8 |
| 104S | 227 | 13235 | 270.0 | 384. | 317. | 49. | 32 | 138.3 | 158. | 49. | 5.5 |
| 106S | 232 | 13723 | 226.5 | 198.5 | 224.0 | 94. | 215. | 132.0 | 175. | 94. | 2.4 |
| 100S | 219 | 12030 | 153.4 | 374. | 204. | 97. | 110. | 175 | 107. | 97. | 1.5 |
| 2dlx 10 | 55 | 3384 | 120.1 | 76. | 80 | 17 | 17 | 4 | 41 | 4 | 30.0 |

Table3

# FIG. 8

(a)

$$(a' + o) (b' + o) (a + b + o')$$
$$(o' + x) (p' + x) (o + p + x')$$
$$(o + y) (q' + y) (o' + q + y')$$
$$(o + z) (r' + z) (o' + r + z')$$

(b)

# FIG. 9

| Design-Property | # FFs | # Gates | Options | Bound k | Witness | Times(s) (+inc) | Times(s) (-inc) | Mem (MB) |
|---|---|---|---|---|---|---|---|---|
| Bus1-P1 | 1735 | 9467 | op1:-T -C | 18 | NO | 6620 | 6709 | 136 |
| | | | op2:-T +C | 20 | YES | 91 | 99 | 28 |
| | | | op3:+T -C | 20 | YES | 294 | 326 | 45.5 |
| | | | op4:+T +C | 20 | YES | 14 | 15 | 10.5 |
| | | | op5:+T +C +H | 20 | YES | 7 | 8 | 7.1 |
| Bus2-P1 | 1997 | 11043 | op1:-T -C | 18 | NO | 4724 | 4754 | 168 |
| | | | op2:-T +C | 23 | YES | 270 | 379 | 67 |
| | | | op3:+T -C | 23 | YES | 602 | 733 | 60.7 |
| | | | op4:+T +C | 23 | YES | 70 | 108 | 21 |
| | | | op5:+T +C +H | 23 | YES | 36 | 51 | 15 |
| Bus3-P1 | 2259 | 12614 | op1:-T -C | 18 | NO | 6369 | 6357 | 205 |
| | | | op2:-T +C | 29 | YES | 7036 | 7502 | 200 |
| | | | op3:+T -C | 29 | YES | 2134 | 9874 | 87 |
| | | | op4:+T +C | 29 | YES | 693 | 3083 | 34.1 |
| | | | op5:+T +C +H | 29 | YES | 300 | 1894 | 37.5 |
| Bus4-P1 | 2703 | 16670 | op1:-T -C | 18 | NO | 9320 | 9402 | 255 |
| | | | op2:-T +C | 18 | NO | 1644 | 1657 | 130 |
| | | | op3:+T -C | 18 | NO | 1207 | 1540 | 91 |
| | | | op4:+T +C | 18 | NO | 170 | 398 | 38 |
| | | | op5:+T +C +H | 18 | NO | 87 | 159 | 34 |
| Dma-P1 | 12 | 328 | op1:-T -C | 72 | NO | 3880 | 3971 | 11 |
| | | | op2:-T +C | 72 | NO | 1969 | 1961 | 9 |
| | | | op3:+T -C | 200 | NO | 2 | 3 | 8 |
| | | | op4:+T +C | 200 | NO | 1 | 1 | 8 |
| | | | op5:+T +C +H | 200 | NO | 6 | 6 | 8 |
| Dma-P1 | 234 | 2495 | op1:-T -C | 20 | NO | 3436 | 5718 | 27 |
| | | | op2:-T +C | 20 | NO | 811 | 1367 | 19 |
| | | | op3:+T -C | 50 | NO | 97 | 578 | 29 |
| | | | op4:+T +C | 50 | NO | 37 | 205 | 21 |
| | | | op5:+T +C +H | 50 | NO | 28 | 242 | 19 |
| D1-P3 | 256 | 1582 | op1:-T -C | 16 | YES | 996 | 1010 | 22 |
| | | | op2:-T +C | 16 | YES | 49 | 55 | 6 |
| | | | op3:+T -C | 16 | YES | 3 | 3 | 7 |
| | | | op4:+T +C | 16 | YES | 1 | 1 | 3 |
| | | | op5:+T +C +H | 16 | YES | 1 | 1 | 2 |
| D1-P4(S) | 256 | 1582 | op1:-T -C | 24 | YES | 8808 | 9107 | 42 |
| | | | op2:-T +C | 24 | YES | 818 | 1076 | 18 |
| | | | op3:+T -C | 24 | YES | 7 | 8 | 10 |
| | | | op4:+T +C | 24 | YES | 3 | 5 | 6 |
| | | | op5:+T +C +H | 24 | YES | 3 | 4 | 5 |
| D1-P5(S) | 256 | 1582 | op1:-T -C | 25 | NO | 8595 | 8668 | 42 |
| | | | op2:-T +C | 25 | NO | 688 | 747 | 17 |
| | | | op3:+T -C | 65 | NO | 5319 | 11758 | 65 |
| | | | op4:+T +C | 65 | NO | 3104 | 9910 | 46 |
| | | | op5:+T +C +H | 65 | NO | 4488 | 11865 | 66 |
| D1-P6(S) | 256 | 1582 | op1:-T -C | 17 | YES | 1741 | 1809 | 26 |
| | | | op2:-T +C | 17 | YES | 127 | 164 | 7 |
| | | | op3:+T -C | 17 | YES | 4 | 5 | 7 |
| | | | op4:+T +C | 17 | YES | 1 | 1 | 3 |
| | | | op5:+T +C +H | 17 | YES | 1 | 1 | 3 |
| D1-P7 | 256 | 1582 | op1:-T -C | 17 | YES | 694 | 725 | 24 |
| | | | op2:-T +C | 17 | YES | 32 | 37 | 7 |
| | | | op3:+T -C | 17 | YES | 2 | 2 | 7 |
| | | | op4:+T +C | 17 | YES | 0 | 0 | 2.8 |
| | | | op5:+T +C +H | 17 | YES | 0 | 0 | 1.9 |
| D2-P1 | 974 | 10940 | op1:-T -C | 21 | YES | 653 | 727 | 45 |
| | | | op2:-T +C | 21 | YES | 8 | 8 | 22.5 |
| | | | op3:+T -C | 21 | YES | 12 | 11 | 41 |
| | | | op4:+T +C | 21 | YES | 4 | 4 | 23.5 |
| | | | op5:+T +C +H | 21 | YES | 3 | 3 | 21 |

Table4:Results for BMC Verification

# FIG.10

| Design | Property | #FF/#G | Status | Depth | Time(s) | Mem (MB) |
|--------|----------|--------|--------|-------|---------|----------|
| D3 | p1 | 90715 | T | 2 | 0.09 | 0.76 |
|    | p2 | 317/2345 | T | 0 | 0.06 | 1.01 |
| D4 | p1 | 7/13. | T | 1 | 0 | 0.28 |
|    | p2 | 57/794 | – | 25 | 24.26 | 17.2 |
|    | p3 | 57/794 | – | 25 | 24.27 | 17.41 |
|    | p4 | 57/794 | – | 25 | 26.79 | 17.37 |
|    | p5 | 57/794 | – | 25 | 24.94 | 17.29 |
|    | p6 | 53/821 | – | 25 | 36.39 | 18.56 |
|    | p7 | 24/85 | T | 0 | 0 | 0.28 |
|    | p8 | 50/818 | T | 0 | 0.02 | 0.42 |
|    | p9 | 6/10. | T | 0 | 0 | 0.27 |
|    | p10 | 19/55 | T | 0 | 0 | 0.28 |
|    | p11 | 20/61 | T | 0 | 0 | 0.28 |
|    | p12 | 35/509 | T | 0 | 0.01 | 0.34 |
|    | p13 | 53/821 | T | 1 | 0.04 | 0.64 |
|    | p14 | 53/821 | T | 0 | 0.02 | 0.42 |
| D5 | p1 | 2198/20221 | T | 0 | 0 | 2.32 |
|    | p2 | 2198/20223 | T | 1 | 0.3 | 4.45 |
|    | p3 | 2198/20224 | – | 5 | 7.73 | 29.1 |
|    | p4 | 2198/20021 | T | 0 | 0 | 2.32 |
|    | p5 | 2198/20226 | T | 1 | 0.29 | 6.32 |
|    | p6 | 2198/20035 | T | 0 | 0.05 | 3.21 |
|    | p7 | 2198/20265 | T | 1 | 0.23 | 6.32 |
|    | p8 | 2198/20266 | – | 5 | 5.87 | 28.6 |
|    | p9 | 2198/20296 | T | 1 | 0.29 | 6.33 |
|    | p10 | 2198/23333 | – | 5 | 8.93 | 36.3 |
|    | p11 | 2198/20225 | T | 1 | 0.31 | 6.32 |
|    | p12 | 2198/20238 | T | 0 | 0.04 | 3.2 |
|    | p13 | 2198/20226 | T | 1 | 0.3 | 6.32 |
|    | p14 | 2198/20248 | T | 0 | 0.06 | 3.21 |
|    | p15 | 2198/20221 | T | 0 | 0.01 | 2.32 |
|    | p16 | 2198/20538 | – | 5 | 14.86 | 31.5 |
|    | p23 | 2201/20259 | – | 5 | 11.63 | 30.9 |

Table 5:Results for Proofs by Induction without Reachability Constraint

# FIG.11

Table 6:Results for Proofs by Induction using Reachability Constraint

| Design | Property | BDD-based Reachability Analysis | | | | BMC-based Proof by Induction | | | | |
|---|---|---|---|---|---|---|---|---|---|---|
| | | #FF/#G | Time (s) | steps | \|BDD\| | #FF/#G | Status | Depth | Time (s) | Mem (MB) |
| D5 | p3 | 41/462 | 1.6 | 7 | 131 | 2198/14702 | T | 0 | 0.07 | 2.72 |
| | p16 | 115/1005 | 15.3 | 12 | 677 | 2265/16079 | T | 0 | 0.11 | 2.84 |
| | p23 | 63/1001 | 18.8 | 18 | 766 | 2204/16215 | T | 0 | 0.1 | 2.85 |

EP 1 515 251 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6324694 B1
- US 2002178424 A1

**Non-patent literature cited in the description**

- **E. M. Clarke ; O. Grumberg ; D. Peled.** Model Checking:. MIT Press, 1999
- **K. L. McMillan.** Symbolic Model Checking: An Approach to the State Explosion Problem:. Kluwer Academic Publishers, 1993
- Symbolic Model Checking without BDDs. **A. Biere ; A. Cimatti ; E. M. Clarke ; Y. Zhu.** Proceedings of Workshop on Tools and Algorithms for Analysis and Construction of Systems (TACAS). LNCS,, 1999, vol. 1579
- **R. E. Bryant.** Graph-based algorithms for Boolean function manipulation. *IEEE Transactions on Computers,* 1986, vol. 35 (8), 677-691
- **M. Sheeran ; S. Singh ; G. Stalmarck.** Checking Safety Properties using Induction and a SAT Solver. *Proceedings of Conference on Formal Methods in Computer-Aided Design,* 2000
- **P. Ashar ; M. Ganai ; A. Gupta ; Z. Yang ; A. Mukaiyama ; K. Wakabayashi.** Formal Verification in an Industrial Setting: DiVer Verification Platform White Paper. *NEC,* 2001
- **P. Ashar ; P. Chauhan ; M. Ganai ; A. Gupta ; Z. Yang ; L. Zhang.** DiVer Document: User Manual - Verification Platform for Digital Systems. *NEC,* 2001
- **P. Ashar ; P. Chauhan ; M. Ganai ; A. Gupta ; Z. Yang ; L. Zhang.** DiVer Document: Tutorial - NEC production design case studies. *NEC,* 2001
- **H. Zhang.** SATO: An efficient propositional prover. *Proceedings of International Conference on Automated Deduction,* 1997, vol. 1249, 272-275
- **M. Moskewicz ; C. Madigan ; Y. Zhao ; L. Zhang ; S. Malik.** Chaff: Engineering an Efficient SAT Solver. *Proceedings of Design Automation Conference,* 2001
- **P. Bjesse ; K. Claessen.** SAT-based verification without state space traversal. *Proceedings of Conference on Formal Methods in Computer-Aided Design,* 2000
- **M. Ganai ; A. Aziz.** Improved SAT-based Bounded Reachability Analysis. *Proceedings of VLSI Design Conference,* 2002

- **O. Shtrichman.** Tuning SAT Checkers for Bounded Model Checking. *Proceedings of International Conference on Computer-Aided Verification,* 2000
- **O. Shtrichman.** Pruning Techniques for the SAT-based bounded model checking. *Proceedings of Workshop on Tools and Algorithms for the Analysis and Construction of Systems (TACAS),* 2001
- **M. Ganai ; L. Zhang ; P. Ashar ; A. Gupta.** Combining Strengths of Circuit-based and CNF-based Algorithms for a High Performance SAT Solver. *NEC,* December 2001
- **A. Biere ; A. Cimatti ; E. M. Clarke ; M. Fujita ; Y. Zhu.** Symbolic model checking using SAT procedures instead of BDDs. *Proceedings of the Design Automation Conference,* 1999, 317-320
- **A. Gupta ; Z. Yang ; P. Ashar ; A. Gupta.** SAT-based Image Computation with Application in Reachability Analysis. *Proceedings of Conference on Formal Methods in Computer-Aided Design,* 2000, 354-371
- **A. Gupta ; A. E. Casavant ; P. Ashar ; X. G. Liu ; A. Mukaiyama ; K. Wakabayashi.** Property-specific testbench generation for guided simulation. *Proceedings of VLSI Design Conference,* 2002
- **J. Kim ; J. Whittemore ; J. P. M. Silva ; K. Sakallah.** Incremental Boolean Satisfiability and its application to delay fault testing. *Proceedings of International Workshop on Logic Synthesis,* 1999
- **A. Kuehlmann ; F. Krohm.** Equivalence Checking using Cuts and Heaps. *Proceedings of Design Automation Conference,* 1997
- **M. Ganai ; A. Kuehlmann.** On-the-fly compression of logical circuits. *Proceedings of International Workshop on Logic Synthesis,* 2000
- **A. Kuehlmann ; M. Ganai ; V. Paruthi.** Circuit-based Boolean Reasoning. *Proceedings of Design Automation Conference,* 2001
- **P. Goel.** An implicit enumeration algorithm to generate tests for Combinational circuits. *IEEE Transactions on Computers,* 1981, 215-222

- **H. Fujiwara ; T. Shimono.** On the Acceleration of Test Generation Algorithms. *IEEE Transactions on Computers,* 1983, 265-272
- **M. Schulz ; E. Trischler ; T. Sarfert.** SOCRATES: A highly efficient ATPG System. *IEEE Transactions on Computer-Aided Design of Integrated Circuits and Systems,* 1988, vol. 7, 126-137
- **M. N. Velev.** *Benchmark Suites.* http://www.ece.cmu.edu/~mvelev, October 2000
- **A. Gupta ; A. Gupta ; Z. Yang ; P. Ashar.** Dynamic detection and removal of inactive clauses in SAT with application in image computation. *Proceedings of Design Automation Conference,* 2001
- **H. Cho ; G. D. Hachtel ; E. Macii ; B. Plessier ; F. Somenzi.** Algorithms for approximate FSM traversal based on state space decomposition. *IEEE Transactions on Computer-Aided Design of Integrated Circuits and Systems,* 1996, vol. 15 (12), 1465-1478
- **I.-H. Moon ; J.-Y. Jang ; G. D. Hachtel ; F. Somenzi ; C. Pixley ; J. Yuan.** Approximate reachability don't-cares for CTL model checking. *Proceedings of the International Conference on Computer-Aided Design.,* 1998
- **K. Ravi ; K. L. McMillan ; T. R. Shiple ; F. Somenzi.** Approximation and decomposition of Decision Diagrams. *Proceedings of the Design Automation Conference.,* 1998, 445-450
- **EMERSON E A et al.** Modalities for model checking: branching time logic strikes back. *SCIENCE OF COMPUTER PROGRAMMING,* 1987, vol. 8 (3), 275-306
- **HAVERKORT B R et al.** On the use of model checking techniques for dependability evaluation. *RELIABLE DISTRIBUTED SYSTEMS,* 10 October 2000, 228-237
- **ABRAHAM J A et al.** Verifying properties using sequential ATPG. *PROCEEDINGS INTERNATIONAL TEST CONFERENCE 2002,* 07 October 2002, 194-202